# EUROPEAN PATENT APPLICATION

(11) **EP 2 894 133 A1**
(43) Date of publication of application: **15.07.2015**
(21) Application number: 14150609.7
(22) Date of filing: 09.01.2014
(51) Int. Cl.: C03C 17/00, C03C 17/245, C03C 17/36, C23C 14/00

(54) **Temperature resistant coating system including TiOx**

(71) Applicant: INTERPANE Entwicklungs-und Beratungsgesellschaft mbH, 37697 Lauenförde (DE)
(72) Inventor: Wagner, Dominik, 37671 Lüchtringen (DE); Weis, Hansjörg, 37671 Höxter (DE); Purwins, Michael, 37170 Uslar / Offensen (DE); Kappertz, Oliver, 37077 Göttingen (DE); Mäder, Sebastian, 52064 Aachen (DE); Wuttig, Matthias, 52074 Aachen (DE); Schmidt, Rüdiger M., 28213 Bremen (DE)
(74) Representative: Körfer, Thomas

(57) **Abstract**

The invention relates to a temperature resistant coating system (102) for a transparent substrate (104). The coating system (102) comprises a layer of titanium oxide (108), wherein the layer of titanium oxide (108) comprises at least one of hafnium, tantalum, tungsten, zirconium, molybdenum, vanadium, chromium, and manganese.

## Description

The present invention relates to a temperature resistant coating system for a transparent substrate, a product comprising the substrate coated with the coating system, and a method of coating the substrate with the coating system.

It is known to provide transparent substrates such as glass or appropriate synthetic materials with coating systems comprising one or more layers of coating for, e.g., adjusting optical properties of the resulting product, such as a transmissivity, for example in a specific wavelength range, for adjusting mechanical properties of the product such as a breaking or fracturing behaviour, and/or for providing mechanical or chemical protection for other coating layers, etc..

Some products which comprise a transparent substrate such as glass undergo a tempering process during their manufacture. Glass products, for instance, may undergo a tempering process wherein the substrate is heated to temperatures of 250°C (degree Celsius) or more for one or more hours, as may be required, for example, for outgassing, passivation, etc.. Another tempering process may comprise heating a substrate to temperatures of 550°C or more for some minutes, as may be required, for example, for hardening a glass substrate, wherein exemplary products include safety glass for use in vehicles or as an architectural glass.

Manufacturing conditions may require that the coating system is applied to the substrate prior to the or any tempering process. Therefore the one or more layers of the coating system have to withstand the tempering process which includes that adverse effects of tempering conditions on desired product properties such as in particular optical properties are minimized. In particular, local differences in coating layer properties after tempering may lead to unwanted haze, striations, shades, etc. of the product.

One or more layers of a coating system for example for glass products may comprise titanium. A layer of oxidized titanium may for example serve as a blocking layer to prevent oxidation of another layer. Titanium oxide has generally a comparatively high refractive index in comparison to, e.g., glass, and therefore a titanium oxide layer may also serve as an antireflection coating.

It is known that a coating layer of titanium oxide when involved in a tempering process can be deteriorated in terms of optical properties of the layer and therefore the coated product such as transparency, brilliancy, etc.. It is assumed that due to the high temperatures applied during the tempering a structure of the titanium dioxide layer may undergo changes. For example, if there is no crystalline structure at the beginning, high temperatures may lead the titanium oxide at least in part adopting a crystal structure such as an anatase structure, rutile structure, or a mixture of both. However, the amorphous and the various crystalline structures differ in volume filling, e.g. in terms of unit cells for the crystalline structures. Therefore, stress or tensions may occur in the layer with resultant formation of cracks which may deteriorate optical properties. Fractures in the titanium oxide layer may also result in loss of oxidation protection and/or may attract moisture with further temporary or permanent deterioration of optical properties.

DE 10 2005 038 139 B4 describes a thermal stress resistant, low emission laminate system for coating transparent substrates, which comprises an antireflective oxide layer, a zinc oxide layer, a silver layer, a blocking layer of titanium alloy, an antireflective layer and a covering layer, wherein the blocking layer is a metallic or weakly nitrided layer of titanium alloy containing 50-97 weight-% titanium and 3-50 weight-% chromium, iron, zirconium and/or hafnium.

The object of the invention is a cost-efficient approach of minimizing adverse effects of tempering on a coating system which includes a titanium oxide layer.

The above object is solved by a coating system according to claim 1, a product comprising the coating system according to claim 10, and a method of coating a substrate with the coating system according to claim 12.

According to one aspect of the invention, a temperature resistant coating system for a transparent substrate is proposed. The system comprises a layer of titanium oxide (TiOₓ). The layer of titanium oxide comprises at least one of hafnium, tantalum, tungsten, zirconium, molybdenum, vanadium, chromium, manganese.

The coating system may comprise only the titanium oxide layer, for example as an antireflection coating and/or for implementing a self-cleaning property. According to other embodiments, the coating system may comprise, besides the titanium oxide layer, one or more other layers, including, for example, one or more further layers of titanium or titanium oxide, a layer of silver and/or one or more other metals or metal alloys, etc..

The coating system may be provided for substrates such as any kind of glass, for instance float glass, sheet glass for windows, doors, balustrades, etc., architectural glass, safety glass, glass with low emissivity ('low-E') properties, but also solar panels or solar cells such as photovoltaic elements, solar heat elements or solar collector elements, etc.. The coating system may also be provided for substrates made from synthetic materials such as plastic glass or synthetic foils, for example foils to be fitted between glass sheets in a manufacture of laminated glass.

A coating system may be designated 'temperature resistant', 'thermally resistant' or 'thermally stress resistant' herein when the system can withstand conditions in a tempering process as it may applied to the substrate. A tempering process may for example be applied for outgassing and/or passivation of the substrate and/or a layer of the coating system, and/or for creating balanced internal stresses in a glass substrate for forming a correspondingly pre-stressed glass product. A tempering process may include, for example a heating to a temperature of at least 250°C, for example a heating to 300°C or more, or may include a heating to at least 550°C, for example to 700°C or more. Some embodiments of a tempering process may also include a combination of the beforementioned heating processes.

The coating system, in particular a titanium oxide layer thereof are said to withstand a tempering process if there is no deterioration of desired properties of the system, the titanium oxide layer, the substrate, and/or the product comprising the coating system and the substrate, or if a deterioration is less than a deterioration occuring without the invention being applied, and/or if a deterioration is defined as acceptable.

One or more layers of the coating system may comprise titanium, in particular titanium oxide. The term 'titanium oxide', sometimes abbreviated with 'TiOₓ' herein, may generally refer to the parallel presence of a variety of oxides of titanium, including, however not necessarily exclusively, in particular dioxides, as is known to the person of skill in the field.

The layer of titanium oxide may be provided for one or more purposes such as a blocking layer, for instance to prevent oxidation of another layer of material such as a metal or metal alloy, e.g. comprising silver. Titanium oxide in general, but also particular crystalline structures of titanium dioxide such as anatase or rutile, are known for a high refractive index in comparison to, e.g., glass. Therefore, additionally or alternatively the layer of titanium oxide may be designed to adjust an anti-reflective property of the coated substrate. Other additional or alternative functions may include the titanium oxide layer serving as an outer or protective layer, e.g. to provide a self-cleaning property of the coated substrate, etc..

The coating system may be provided with the layer of titanium oxide prior to one or more or any tempering process. This is to be understood in contrast to known techniques of providing, for example, a layer of titanium nitride which is intended to be oxidized during a tempering.

As to notation used herein, a layer to be protected from oxidation such as a silver layer may be provided on one side of a substrate, wherein that side may arbitrarily be referred to as 'upper' side and the layer to be protected is provided 'above' the substrate. Further in that reference frame, a titanium oxide layer may be provided, for example, as a blocking layer, and may therefore be provided 'above' the layer to be protected, i.e. on that side of the layer to be protected which is opposite to the substrate. According to various corresponding embodiments, a silver layer may be positioned above a glass substrate, and a titan oxide layer may be positioned above the silver layer.

The layer of titanium oxide may have a high refractive index of at least 2.0, preferably 2.4, more preferably 2.45, most preferably 2.48, or more prior to any tempering process.

According to various preferred embodiments, the layer of titanium oxide may comprise hafnium. According to some of these embodiments, which may be provided in particular, but not exclusively, for a tempering process of the coated substrate with temperatures reaching values above 550°C, the layer of titanium oxide comprises a percentage of hafnium in the range of 1 - 4 at.% (atomic percent), preferably 2 - 3 at.%. As used generally herein, a value given in units of at.% designates a value of a mass fraction X / (titanium + X) as measured for example in the titanium oxide layer and/or during a coating of the titanium oxide layer to the substrate. X designates any one of hafnium, tantalum, tungsten, zirconium, molybdenum, vanadium, chromium, and manganese.

According to various embodiments, the layer of titanium oxide may comprise tantalum. According to some of these embodiments, which may be provided in particular, but not exclusively, for a tempering process of the coated substrate with temperatures reaching values above 550°C, the layer of titanium oxide may comprise a mass fraction of tantalum in the range of 2 - 6 at.%, preferably 3.5 - 5 at.%.

According to various embodiments, the layer of titanium oxide may comprise tungsten. According to some of these embodiments, which may be provided in particular, but not exclusively, for a tempering process of the coated substrate with temperatures reaching values above 250°C, but below 350°C, or below 550°C, the layer of titanium oxide may comprise a mass fraction of tungsten in the range of 1.5 at.% - 2.2 at.%.

According to various embodiments, the layer of titanium oxide may comprise zirconium. According to various embodiments, which may be provided in particular, but not exclusively, for a tempering process of the coated substrate with temperatures reaching values above 550°C, the layer of titanium oxide may comprise a mass fraction of zirconium in the range of 0.8 - 1.8 at.%, preferably 1 - 1.5 at.%.

According to various embodiments, the layer of titanium oxide may comprise molybdenum.

According to various embodiments, the layer of titanium oxide may comprise vanadium. According to various embodiments, which may be provided in particular, but not exclusively, for a tempering process of the coated substrate with temperatures reaching values above 550°C, the layer of titanium oxide may comprise a mass fraction of vanadium in the range of 1.0 - 1.6 at.%, preferably 1.1 - 1.5 at.%.

According to various embodiments, the layer of titanium oxide may comprise chromium. According to some of these embodiments, which may be provided in particular, but not exclusively, for a tempering process of the coated substrate with temperatures reaching values above 250°C, but below 350°C, or below 550°C, the layer of titanium oxide may comprise a mass fraction of chromium in the range of 2.5 at.% or more, preferably 3.2 at.% or more, more preferably 3.9 at.% or more.

According to other embodiments, which may be provided in particular, but not exclusively, for a tempering process of the coated substrate with temperatures reaching values above 550°C, the layer of titanium oxide may comprise a mass fraction of chromium in the range of 1.8 - 3.1 at.%, preferably 2.1 - 3.0 at.%.

According to various embodiments, the layer of titanium oxide may comprise manganese.

According to one aspect of the invention, a product is proposed which comprises a substrate coated with a coating system as outlined above and/or described elsewhere herein. Various substrates can be contemplated, which are also exemplarily described above or elsewhere herein. According to various embodiments, the product may comprise at least one of sheet glass, low-E glass, architectural glass, safety glass, antireflective glass, and glass for solar panels.

According to various embodiments, the product has been subjected to a tempering process with temperatures reaching at least 250°C, or at least 300°C. Additionally or alternatively, the product may have been subjected to a tempering process with temperatures reaching at least 550°C, or at least 700°C.

According to one aspect of the invention, a method of coating a substrate with a coating system is proposed. The coating system may comprise the features as outlined above and/or described elsewhere herein. The method comprises performing a sputtering process for coating the substrate with the titanium oxide layer.

The sputtering process may comprise one or more of the following techniques: DC ("direct current") / AC ("alternating current") sputtering, HF ("high frequency") / RF ("radio frequency") sputtering, reactive sputtering, gas flow sputtering, ion beam sputtering, magnetron sputtering including HiPIMS ("high power impulse magnetron sputtering"), etc..

The substrate may be coated in a plant comprising a sputtering target which provides, for forming the titanium oxide layer on the substrate, a coating material for ejection during a sputtering process and deposition on the substrate. The coating material may comprise titanium. The sputtering target may further provide, at least during the sputtering process, a dopant material such as hafnium, tantalum, tungsten, zirconium, molybdenum, vanadium, chromium, manganese in order that the layer of titanium oxide formed on the substrate is doped with the dopant material, for example according to the atomic percentage values outlined above and/or described elsewhere herein.

According to various embodiments, the sputtering process may comprise sputtering the titanium oxide layer to include hafnium. According to some of these embodiments, which may in particular, but not exclusively, comprise providing a temperature resistant coating system for a tempering process of the coated substrate with temperatures reaching values above 550°C, the sputtering process comprises that an oxygen flux is set to a value between 0.2 sccm (standard cubic centimeters per minute) - 2.0 sccm, preferably 0.5 sccm - 1.5 sccm, after a transition point.

The term 'transition point' refers to selecting an operating point at a transition mode of a sputtering process, as is known by the skilled person. For example, the last oxidic operating point before the metallic regime may be selected along a return path. The indicated values of oxygen flux 'after a transition point' in this respect refer more precisely to excess oxygen fluxes.

According to various embodiments, the sputtering process may comprise sputtering the titanium oxide layer to include tantalum. According to some of these embodiments, which may in particular, but not exclusively, comprise providing a temperature resistant coating system for a tempering process of the coated substrate with temperatures reaching values above 550°C, the sputtering process further comprises that an oxygen flux is set to a value between 1.5 sccm - 3.5 sccm after a transition point.

According to various embodiments, the sputtering process may comprise sputtering the titanium oxide layer to include tungsten. According to some of these embodiments, which may in particular, but not exclusively, comprise providing a temperature resistant coating system for a tempering process of the coated substrate with temperatures reaching values above 250°C, but below 350°C, or below 550°C, the sputtering process further comprises that an oxygen flux is set to a value of 0.5 sccm or more, preferably 1.0 sccm or more, more preferably 1.5 sccm or more, after a transition point.

According to various embodiments, the sputtering process may comprise sputtering the titanium oxide layer to include zirconium. According to some of these embodiments, which may in particular, but not exclusively, comprise providing a temperature resistant coating system for a tempering process of the coated substrate with temperatures reaching values above 550°C, the sputtering process further comprises that an oxygen flux is set within a range of 1 sccm - 4 sccm, preferably 1.5 sccm - 3.5 sccm, after a transition point.

According to various embodiments, the sputtering process may comprise sputtering the titanium oxide layer to include molybdenum.

According to various embodiments, the sputtering process may comprise sputtering the titanium oxide layer to include vanadium. According to some of these embodiments, which may in particular, but not exclusively, comprise providing a temperature resistant coating system for a tempering process of the coated substrate with temperatures reaching values above 550°C, the sputtering process further comprises that an oxygen flux is set within a range of 1 sccm - 4 sccm, preferably 1.5 sccm - 3.5 sccm, after a transition point.

According to various embodiments, the sputtering process may comprise sputtering the titanium oxide layer to include chromium. According to a first set of these embodiments, which may in particular, but not exclusively, comprise providing a temperature resistant coating system for a tempering process of the coated substrate with temperatures reaching values above 250°C, but below 350°C, or below 550°C, the sputtering process further comprises that an oxygen flux is set to a value of 2.5 sccm or more, preferably 3.5 sccm or more, after a transition point.

According to a second set of these embodiments, which may or may not overlap with the first set of embodiments, and which may in particular comprise providing a temperature resistant coating system for a tempering process of the coated substrate with temperatures reaching values above 550°C, the sputtering process further comprises that an oxygen flux is set to a value between 1.0 sccm - 3.5 sccm, preferably between 1.5 sccm - 3.0 sccm, after a transition point.

According to various embodiments, the sputtering process may comprise sputtering the titanium oxide layer to include manganese.

According to various embodiments of the invention, for products coated with a coating system comprising at least a layer of doped titanium oxide, deterioration of optical properties during a tempering process can be avoided or minimized in comparison to a similar product except that the titanium oxide layer is undoped. The titanium oxide layer may be doped with a dopant such as hafnium, tantalum, tungsten, zirconium, molybdenum, vanadium, chromium, and/or manganese.

Providing a dopant as before to for a titanium oxide layer can be performed based on one or more processes known as such. For example, a sputtering process for coating a substrate may be modified in order that during the sputtering the coated layer is doped with a dopant. According to various embodiments of the invention, particular dopant concentrations can be intended to be achieved and/or a particular process control of the doping / coating process can be intended, which may include controlling an oxygen flux during a sputtering process in an appropriate way.

Experimental results surprisingly show that when using one or more of the mentioned dopants, optionally with concentrations (mass fractions) and/or oxygen fluxes during sputtering as indicated herein, adverse effects of tempering on a coating system which includes a titanium oxide layer can be minimized. It is assumed that providing one or more of the above dopants, optionally in an appropriate concentration, amongst others acts to minimize occurrence of fractures in the coating layer during a tempering process.

For example, crystallization properties of the titanium oxide layer may be affected by the dopant, e.g. by the dopant perturbing a crystallization, i.e. formation of crystal structures of the titanium oxide layer during tempering, the dopant and/or an associated oxygen flow affecting a sputtering rate, etc. Taking one these examples further, in comparison to an undoped titanium oxide layer, modifications of (crystal) structure may comprise less structures or structures of only one specific form such as either anatase without rutile, or rutile without anatase, etc. A less prominent crystal phase or only one crystal form instead of two or more forms may lead to a reduction of stress in the titanium oxide layer.

According to various embodiments, the titanium oxide layer may have an amorphous structure prior to any tempering process. Then the process of doping of the layer and/or the presence of at least one of the above dopants may act to minimize formation of crystals in layer which may otherwise form due to a tempering.

With the invention, a coating system and/or pre-product (including a coating system and a substrate) with an accordingly doped titanium oxide layer can flexibly be provided, wherein a further manufacturing may or may not include a tempering process. In other words, one and the same coating system / pre-product may be applied for a diversity of final products including or not a tempered substrate. Complexity of manufacturing processes and therefore costs for the manufacture of either of these products can be reduced.

According to various embodiments, proposed dopant materials may easily be introduced into existing manufacturing processes. For example, adding a dopant material to a sputtering process is a procedure known from providing dopant materials for reasons other than that of the present invention. Process control such as use of a reactive gas flow, e.g., an oxygen gas flow, controlling process parameters such as a flux of the reactive gas flow, etc. are also known in the field as such and therefore require minor modification only for implementing the invention.

The invention makes available a variety of new options for manufacturing titanium oxide coated substrates and corresponding products with advantageous properties as desired. For example, new combinations of, on the one hand, desired optical properties and, on the other hand, desired costs can be realized.

Various of the proposed dopant materials are available for low costs compared to costs of other product components. Based on various of the proposed dopant materials, products with particularly advantageous properties can be realized, as discussed in detail below.

Various of the proposed dopant materials enable, for example, provision of cost-efficient and/or particularly advantageous products such as sheet glass, low-E glass, architectural glass, safety glass, etc..

In the following, the invention will further be described with reference to exemplary embodiments illustrated in the figures, in which:
- Fig. 1: schematically illustrates a product including a coating system on a substrate in a status of being manufacturing in a coating plant;
- Fig. 2: is a flow diagram outlining a manufacture of the product of Fig. 1;
- Fig. 3A: is a graph indicating as an experimental result a crystallization of a titanium oxide layer without any dopant material and without any tempering process;
- Fig. 3B: is a graph illustrating as an experimental result a crystallization of a titanium oxide layer without any dopant material and after a tempering process including a heating to 300°C;
- Fig. 3C: is a graph illustrating as an experimental result a crystallization of a titanium oxide layer without any dopant material and after a tempering process including a heating to 700°C;
- Fig. 4: is a graph illustrating refractive index after tempering vs. oxygen flow in a sputtering configuration for the arrangements of Figs. 3A, 3B, 3C;
- Fig. 5: is a graph illustrating a mass fraction for various dopants according to the invention vs. oxygen flow in a sputtering configuration;
- Fig. 6A: is a graph illustrating as an experimental result a crystallization of a titanium oxide layer with hafnium as a dopant material and without any tempering process;
- Fig. 6B: is a graph illustrating as an experimental result a crystallization of a titanium oxide layer with hafnium as a dopant material and after a tempering process including a heating to 300°C;
- Fig. 6C: is a graph illustrating as an experimental result a crystallization structure of a titanium oxide layer with hafnium as a dopant material and after a tempering process including a heating to 700°C;
- Fig. 7: is a graph illustrating refractive index after tempering vs. oxygen flow in a sputtering configuration for the arrangements of Figs. 6A, 6B, 6C;
- Fig. 8A: is a graph illustrating as an experimental result a crystallization of a titanium oxide layer with tantalum as a dopant material and without any tempering process;
- Fig. 8B: is a graph illustrating as an experimental result a crystallization of a titanium oxide layer with tantalum as a dopant material and after a tempering process including a heating to 300°C;
- Fig. 8C: is a graph illustrating as an experimental result a crystallization of a titanium oxide layer with tantalum as a dopant material and after a tempering process including a heating to 700°C;
- Fig. 9: is a graph illustrating refractive index after tempering vs. oxygen flow in a sputtering configuration for the arrangements of Figs. 8A, 8B, 8C;
- Fig. 10A: is a graph illustrating as an experimental result a crystallization of a titanium oxide layer with tungsten as a dopant material and without any tempering process;
- Fig. 10B: is a graph illustrating as an experimental result a crystallization of a titanium oxide layer with tungsten as a dopant material and after a tempering process including a heating to 300°C;
- Fig. 10C: is a graph illustrating as an experimental result a crystallization of a titanium oxide layer with tungsten as a dopant material and after a tempering process including a heating to 700°C;
- Fig. 11: is a graph illustrating a refractive index after tempering vs. oxygen flow in a sputtering configuration for the arrangements of Figs. 10A, 10B, 10C;
- Fig. 12A: is a graph illustrating as an experimental result a crystallization of a titanium oxide layer with zirconium as a dopant material and without any tempering process;
- Fig. 12B: is a graph illustrating as an experimental result a crystallization of a titanium oxide layer with zirconium as a dopant material and after a tempering process including a heating to 300°C;
- Fig. 12C: is a graph illustrating as an experimental result a crystallization of a titanium oxide layer with zirconium as a dopant material and after a tempering process including a heating to 700°C;
- Fig. 13: is a graph illustrating a refractive index after tempering vs. oxygen flow in a sputtering configuration for the arrangements of Figs. 12A, 12B, 12C;
- Fig. 14A: is a graph illustrating as an experimental result a crystallization of a titanium oxide layer with molybdenum as a dopant material and without any tempering process;
- Fig. 14B: is a graph illustrating as an experimental result a crystallization of a titanium oxide layer with molybdenum as a dopant material and after a tempering process including a heating to 300°C;
- Fig. 14C: is a graph illustrating as an experimental result a crystallization of a titanium oxide layer with molybdenum as a dopant material and after a tempering process including a heating to 700°C;
- Fig. 15: is a graph illustrating a refractive index after tempering vs. oxygen flow in a sputtering configuration for the arrangements of Figs. 14A, 14B, 14C;
- Fig. 16A: is a graph illustrating as an experimental result a crystallization of a titanium oxide layer with vanadium as a dopant material and without any tempering process;
- Fig. 16B: is a graph illustrating as an experimental result a crystallization of a titanium oxide layer with vanadium as a dopant material and after a tempering process including a heating to 300°C;
- Fig. 16C: is a graph illustrating as an experimental result a crystallization of a titanium oxide layer with vanadium as a dopant material and after a tempering process including a heating to 700°C;
- Fig. 17: is a graph illustrating a refractive index after tempering vs. oxygen flow in a sputtering configuration for the arrangements of Figs. 16A, 16B, 16C;
- Fig. 18A: is a graph illustrating as an experimental result a crystallization of a titanium oxide layer with chromium as a dopant material and without any tempering process;
- Fig. 18B: is a graph illustrating as an experimental result a crystallization of a titanium oxide layer with chromium as a dopant material and after a tempering process including a heating to 300°C;
- Fig. 18C: is a graph illustrating as an experimental result a crystallization of a titanium oxide layer with chromium as a dopant material and after a tempering process including a heating to 700°C; and
- Fig. 19: is a graph illustrating a refractive index after tempering vs. oxygen flow in a sputtering configuration for the arrangements of Figs. 18A, 18B, 18C.

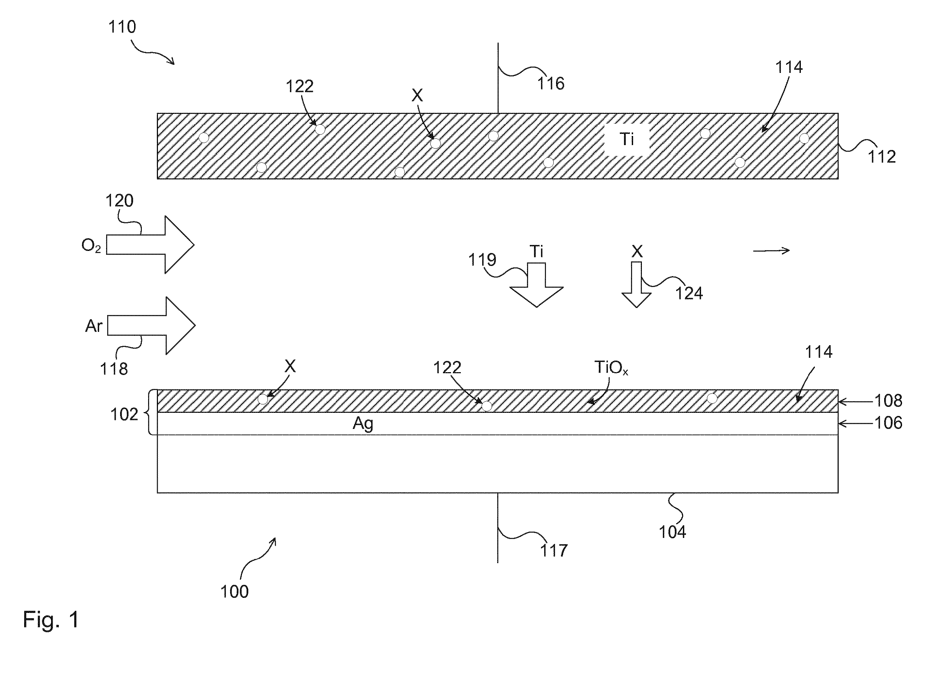

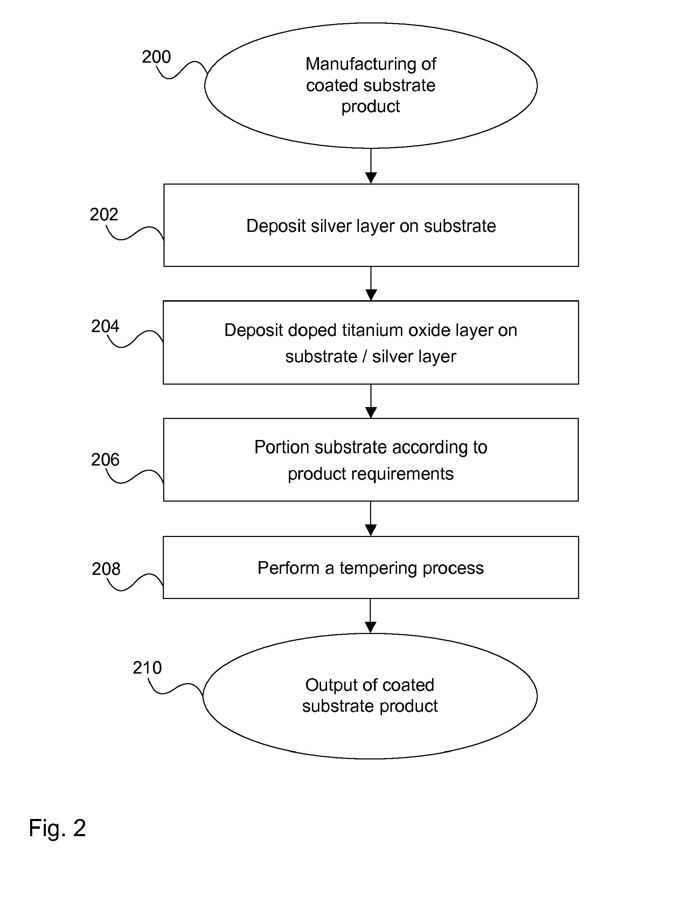

Fig. 1 schematically illustrates a product 100 including a coating system 102 on a substrate 104. The substrate 104 may be assumed a sheet glass and product 100 a safety glass or an architectural glass. The product 100 is illustrated prior to completion, i.e. in an intermediate manufacturing phase. A manufacturing process 200 for manufacturing the product 100 will be described with reference to the flow diagram in Fig. 2.

Generally, the manufacturing process 200 relates to providing the coating system 102 and coating the substrate 104 with the coating system 102, and optionally subjecting the coated substrate / product 100 a tempering process.

More specifically, substrate 104 may exemplarily comprise glass intended for sheet glass, architectural glass, safety glass, etc., wherein substrate 104 may be intended for undergoing the abovementioned tempering process for reasons of passivation and/or hardening. The coating system 102 is intended to be temperature resistant in order that, when subjected to the tempering process, deterioration of any desired property of the coating system 102 or product 100 is minimized, which may for example particularly concern optical properties such as a transparency, brilliancy, etc.. The coating system 102 may for example be intended for the substrate 104 after coating being portioned batch-wise, wherein one batch may be subjected to no tempering, while another batch may be subjected to tempering.

Referring to Fig. 2, in an optional step 202 the substrate 104 may have been coated with a silver (Ag) layer 106 of coating system 102, i.e. the silver layer 106 is deposited on substrate 104. The step may additionally comprise coating the substrate 104 and/silver layer 106 with other layers in an arbitrary sequence of providing the layers on substrate 104, although no such layers are shown in Fig. 1.

In step 204, the substrate 104 / silver layer 106 is coated with a titanium oxide (TiOₓ) layer 108, for example in order to provide a blocker layer above silver layer 106.

As illustrated in Fig. 1, a coating plant including a sputtering configuration 110 is provided, which comprises a sputtering target 112 having a coating material 114. Specifically, the coating material 114 may comprise titanium (Ti). In Fig. 1, portions comprising the coating material 114 of each of the sputtering target 112 and the coating system 102 are depicted with hatching. In particular, Fig. 1 illustrates a coating status wherein as a result of a sputtering process performed with the sputtering configuration 110 the coating layer 108 comprising the coating material 114 is already present at least in part on substrate 102 / silver layer 106.

In order to perform the sputtering process, the sputtering configuration 110 may for example be embodied as a DC-and/or AC-sputtering. Other sputtering processes based on, e.g., ion beam bombardment can be contemplated by the person of skill. Electrical circuitry 116, 117 may be provided for arranging a DC- and/or AC-voltage between target 112 and substrate 104, wherein it is to be understood that the illustration of electrical circuitry 116, 117 is purely schematic. In cases in which neither substrate 104 nor coating system 102 may function as an electrode, one or more anodes 117 may be formed by auxiliary structures as illustrated in Fig. 1.

With further regard to sputtering configuration 110, arrow 118 indicates provision of an inert gas such as, in this case, argon (Ar) which provides ions for bombarding target 112. As a result of the bombardment, particles of the coating material 114 are ejected from the target 112. As indicated by arrow 119, the ejected titanium particles move towards substrate 104 / silver layer 106 and are deposited thereupon for forming the coating layer 108.

More specifically, arrow 120 indicates provision of a reactive gas such as, in this case, oxygen (O₂) which may support forming the coating layer 108 of titanium oxide (TiOₓ) and in particular titanium dioxide (TiO₂). For example, the coating plant providing for the sputtering configuration 110 may provide a process chamber enabling reactions such as between ejected titanium particles 113 and the reactive gas O₂ 120. As is intended to also being indicated by arrow 119, at least part of the reacted TiOₓ particles moves towards substrate 104/106 to form the coating layer 108. As is known to the person of skill in the field, a sputtering operation of sputtering the target material 114 / reacted material 119 to the substrate 104/106 may be controlled by controlling the oxygen flow 120.

In the example illustrated in Fig. 1, the sputtering target 112 comprises the coating material 114; for example, the target 112 may essentially be made of titanium, a titanium alloy, titanium dioxide, etc. Further, the target 112 may be doped, i.e. a dopant X or dopant material 122 be added. Portions or areas of the sputtering target 112 and the coating layer 108 comprising the dopant material 122 are depicted with circlets in Fig. 1.

In the configuration of Fig. 1, the dopant material 122 may be mixed with the coating material 114 throughout target 112, wherein 'mixing' may comprise a purely mechanical merging or blending and/or chemical composition comprising coating 114 and dopant 122 material. According to other configurations, additionally or alternatively a dopant material may be provided in a geometrical configuration different from that of the target material. For example, the dopant material may be provided as a layer on the sputtering target.

As a result of ion bombardment in the exemplary sputter configuration 110 of Fig. 1, besides particles of the coating material 114 also particles of the dopant material 122 are ejected from the target 112 during the sputtering process. As indicated by arrow 124, some of the dopant material 122 of dopant X is deposited on substrate 102/106 in the coating layer 108.

In optional step 206, a portioning or cutting of substrate 104 with coating system 102 is performed, wherein, for example, a blanket sheet of coated glass may be portioned into a plurality of glass sheets with dimensions specifically conforming to their intended use in one or more types of end products.

In step 208, the substrate 104 provided with coating system 102 including coating layer 108 is subjected to a tempering process. Any corresponding heating process may be performed when the product 100 in its pre-product form as illustrated in Fig. 1, optionally after portioning, is still located in the sputtering configuration 110 and/or after transport of the product 100 into a different configuration, e.g. a chamber specifically provided for the tempering and optionally further manufacturing steps.

The tempering process of step 208 may comprise one heating interval, or several heating intervals. According to some embodiments, a tempering process may comprise heating the coated substrate on timescales of order hours to temperatures above 250°C. According to an exemplary specific embodiment, a tempering process may comprise heating the coated substrate for 2 hours to a temperature of 300°C. According to other embodiments, a tempering process may comprise heating the coated substrate on timescales of order minutes to temperatures above 550°C. According to an exemplary specific embodiment, a tempering process may comprise heating the coated substrate for 10 minutes to a temperature of 700°C.

In step 210 the manufacturing process 200 terminates. For example, the product 100 may then comprise a batch of sheet glass which has been coated, portioned and tempered.

Surprisingly it has been found that a deterioration of desired properties of the layer of titanium oxide 108 during the tempering process of step 208 can be minimized when selecting a dopant X in the preceding sputtering process specifically according to its ability for minimizing any such deterioration. The dopant material 122 may comprise at least one of hafnium, tantalum, tungsten, zirconium, molybdenum, vanadium, chromium, and manganese, optionally with a concentration in a specific range of concentration values and/or sputtered with an oxygen flow 120 in a specific range of flow values. Experimental results illustrating appropriate dopant materials are discussed below in more detail.

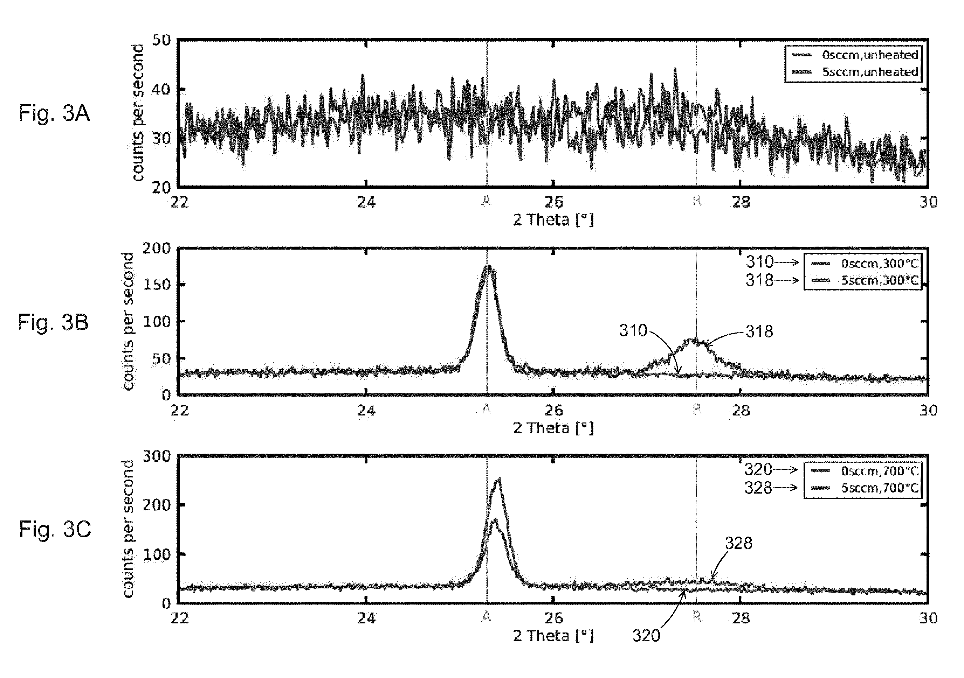

Figs. 3A, 3B and 3C indicate experimental results regarding a crystal structure of a titanium oxide (TiOₓ) layer which may be an implementation of layer 108 of Fig. 1. Specifically, the TiOₓ layer has been sputtered but in contrast to the configuration of Fig. 1 none of the dopants discussed herein have been used in the sputtering process.

The figures show graphs of 'counts per second' vs. scattering angle, wherein the count rate may have been determined by spectroscopic measurements, e.g. Rutherford backscattering spectroscopy. The scattering angle is arbitrarily indicated as "2 Theta" in units of degrees (°). Preferred scattering angles for the crystal structures anatase (A) and rutile (R) are indicated by vertical lines.

Fig. 3A indicates a crystallization of an undoped titanium oxide layer prior to any tempering, i.e. without any heating. Specifically, according to Fig. 3A the sputtered, dopant-free and unheated titanium oxide layer has an entirely amorphous structure. In particular, there is no preference for a crystal structure such as anatase or rutile.

Fig. 3B indicates a crystallization of an undoped titanium oxide layer after a tempering process including a heating to 300°C. In contrast to the amorphous layer structure prior to tempering as shown in Fig. 3A, presence of pronounced crystalline structures are indicated by the peaks of the two graphs given in Fig. 3B.

Specifically, two different oxygen flows 310, 318 are shown, which can be understood as implementations of the oxygen flow 120 of Fig. 1. The oxygen flows 310, 318 are indicated in units of sccm (standard cubic centimeters per minute); more precisely, an excess oxygen flow after a transition point is indicated, wherein the transition point may be selected as the last oxidic operating point before the metallic regime along a return path of a hysterese behaviour for a sputtering configuration, as known to the skilled person. Therefore, even if oxygen flow 310 is indicated with "0 sccm", flow 310 in fact includes a finite amount of an oxygen flow which is different from a vanishing oxygen flow.

As shown in Fig. 3B, due to the heating, crystal structures have been formed in the TiOₓ layer for both the excess oxygen flows 310, 318 of 0 sccm and 5 sccm, respectively. Independent of excess oxygen flow, pronounced anatase structures are present. Further, for an (excess) oxygen flow of 5 sccm, additional rutile structures have formed in the layer. It is assumed that the general formation of crystalline structures during the tempering process, as illustrated in Fig. 3B, and moreover the formation of two different crystalline structures, such as anatase and rutile, with different unit cell sizes can lead to stresses in the titanium oxide layer which may then further result in crack formation and corresponding deterioration of optical properties.

Fig. 3C indicates a crystallization of an undoped titanium oxide layer after a tempering process including a heating to 700°C. Experimental results are presented for two different excess oxygen flows 320, 328 of 0 sccm and 5 sccm, respectively. Due to the tempering, again the titanium oxide layer has changed its structure as compared to Fig. 3A. In particular, pronounced anatase structures are again present. For an oxygen flow 320 of 0 sccm, the anatase structures are more prominent as for an oxygen flow 328 of 5 sccm. On the other hand, for the oxygen flow 328, measurable rutile structures have additionally formed in the layer.

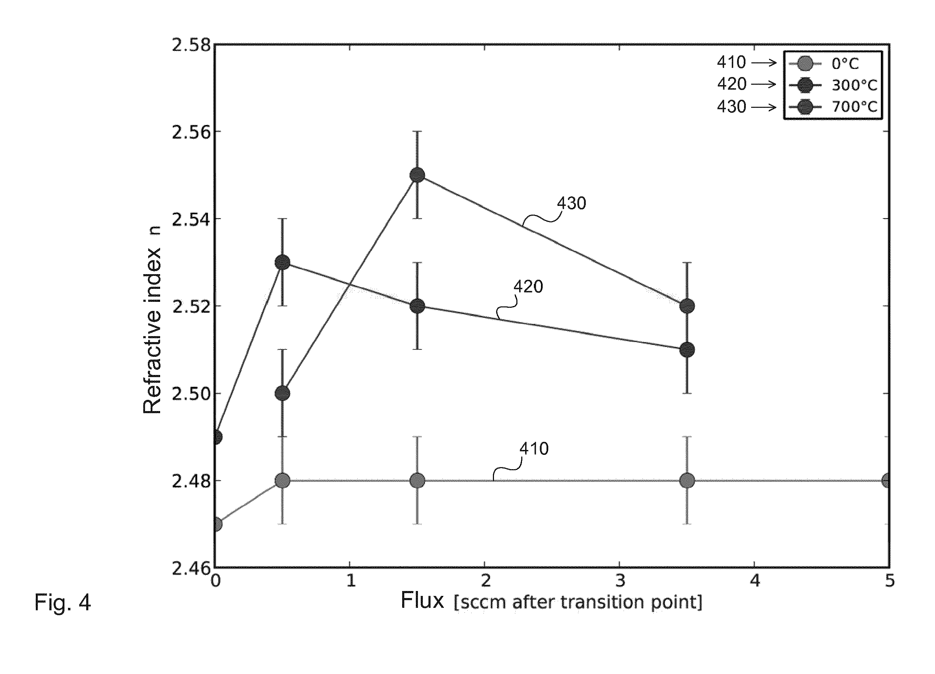

Fig. 4 indicates various graphs of refractive index n of the titanium oxide layers of Figs. 3A, 3B and 3C vs. oxygen flow during sputtering of the titanium oxide layers. Generally, the presence or absence of specific crystal structures can result in a change of refractive index compared to, e.g., an amorphous structure. For example, it is known that anatase and rutile structures, respectively, can lead to different refractive indices.

Specifically, graph 410 indicates refractive indices n for the undoped titanium oxide layer without any heating for various oxygen flows, as depicted in Fig. 3A. Graph 420 indicates refractive indices n for an undoped titanium oxide layer with a heating to 300°C for various oxygen flows, as depicted in Fig. 3B. Graph 430 indicates refractive indices n for an undoped titanium oxide layer with a heating to 700°C for various oxygen flows, as depicted in Fig. 3C.

As illustrated in Fig. 4, a refractive index of the titanium oxide coating layer generally increases due to tempering. It is assumed that the formation of crystal structures including anatase and/or rutile contributes significantly to the change in index. However, a constant index would be generally preferable, i.e. an index which is indifferent to whether a tempering process is applied, and which kind of tempering process is applied, to the titanium oxide layer. A constant index would enable common manufacturing processes for pre-products regardless of whether or not some or all of the products are, after coating, subjected to a tempering.

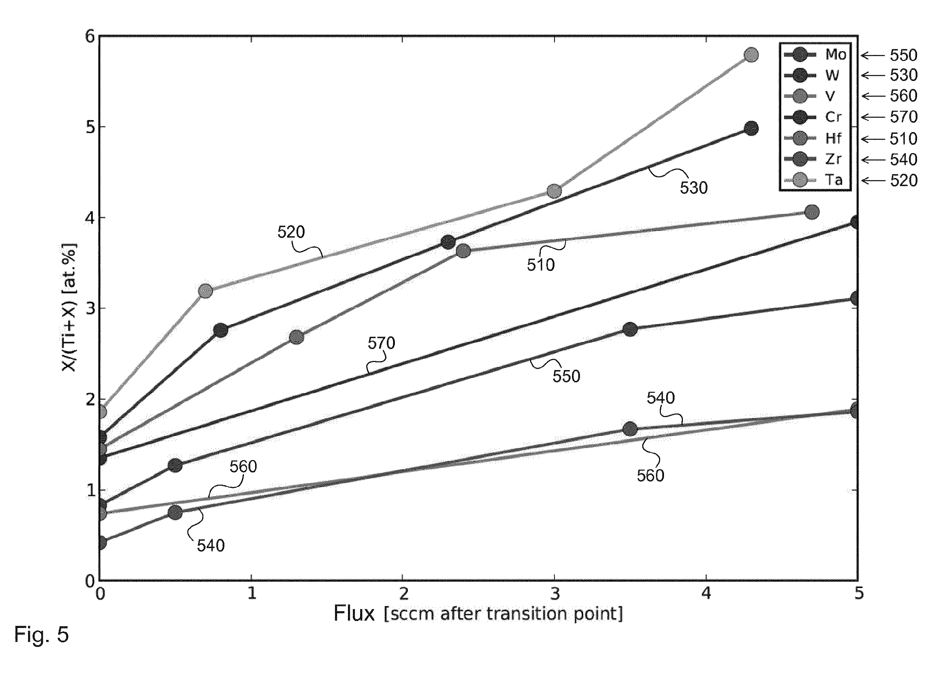

Fig. 5 illustrates mass fraction vs. oxygen flow for various dopants, which may represent specific implementations of the dopant 'X' in Fig. 1. Specifically, mass fractions X / (Ti + X) in atomic percent (at.%) have been measured for various dopants X in a sputtering configuration for sputtering a correspondingly doped titanium (Ti) oxide coating layer. The dopants X comprise hafnium (510), tantalum (520), tungsten (530), zirconium (540), molybdenum (550), vanadium (560), and chromium (570).

As generally shown in Fig.5, changing an oxygen flow results in a change in dopant mass fraction. This is however not to be understood such that structures and properties of doped titanium oxide layers are solely based on differences in dopant mass fraction. Additionally or alternatively other effects can be contemplated such as variations in deposition rates, influences of dopant material and/or oxygen flux on nucleation for forming crystal structures, etc..

Regarding varying excess oxygen flows as shown in Fig. 5, it is noted that for various appliances there may be a preference for excess flows near to the transition point, i.e. near to a flux of 0 sccm as indicated in Fig. 5 and many other diagrams presented herein. For example, minimizing an oxygen flux during sputtering may minimize adverse effects on the titanium oxide layer such as additional contamination of the titanium oxide layer. For other appliances, minimizing the oxygen flow may be less prioritized compared to other desired effects, which may include effects specific for particular dopants as discussed hereinbelow.

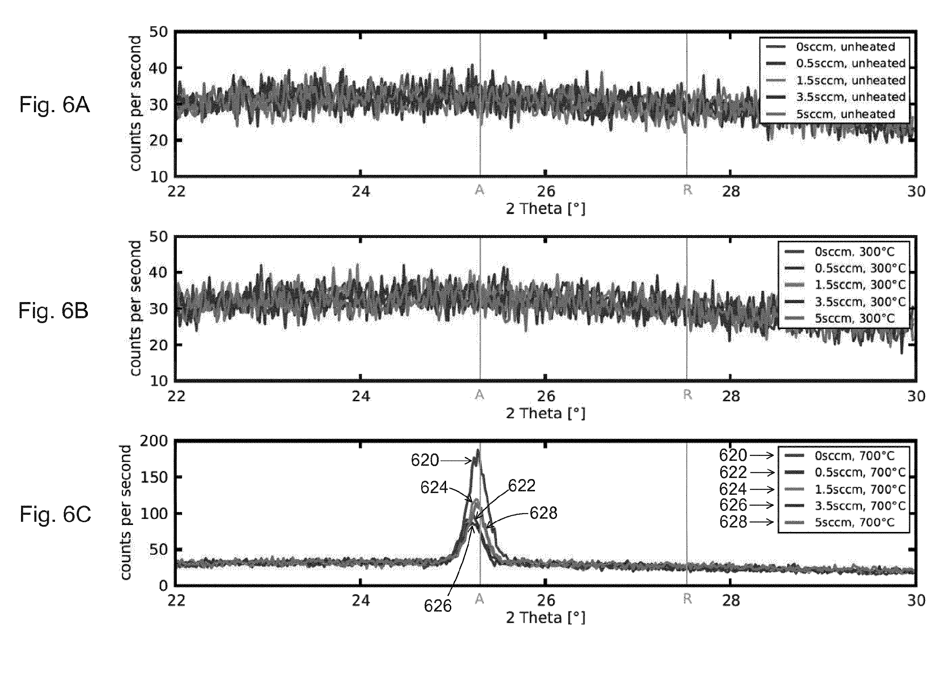

Figs. 6A, 6B and 6C indicate in a similar way as has been discussed for Figs. 3A - 3C experimental results regarding a crystallization of a titanium oxide (TiOₓ) layer with hafnium as a dopant material.

Fig. 6A indicates a crystallization of a titanium oxide layer with hafnium prior to any tempering, i.e. without any heating, for different oxygen flows. According to Fig. 6A, the titanium oxide layer with dopant and without heating has an amorphous structure without any preference for a crystalline structure such as anatase or rutile.

Fig. 6B indicates a crystallization of a titanium oxide layer with hafnium after a tempering process including a heating to 300°C. The crystallization is indicated for various excess oxygen flows between 0 sccm and 5 sccm.

Although being heated, the doped titanium oxide layer essentially remains amorphous as compared to Fig. 6A. In particular, no measurable crystalline structures are present, neither anatase nor rutile, which is in contrast to the undoped titanium oxide layer of Fig. 3B showing the presence of pronounced crystal structures.

Fig. 6C indicates a crystallization of a titanium oxide layer doped with hafnium after a tempering process including a heating to 700°C. The crystallization is indicated for oxygen flows of 0 sccm (620), 0.5 sccm (622), 1.5 sccm (624), 3.5 sccm (626), and 5 sccm (628) after the transition point.

Generally, due to tempering the titanium oxide layer has changed its crystallization as compared to Fig. 6A, i.e. anatase structures are present in the tempered layer. However, the presence of any rutile structure can be prevented even for high excess oxygen flows. This is an advantage over the undoped titanium oxide layer of Fig. 3C, which would require high oxygen flows (328) to minimize occurrence of anatase crystals, however at the cost of formation of rutile structures.

Further it is noted from a comparison of the peak count rates of Figs. 6C and 3C that doping with hafnium enables minimizing a presence of anatase in the titanium oxide layer already for moderate oxygen flows which are considerably lower than that required for an undoped layer. For example, according to various embodiments a sputtering process may comprise sputtering the titanium oxide layer doped with hafnium and controlling an excess oxygen flux to be 0.2 sccm or more, preferably 0.5 sccm or more. According to various embodiments, the layer of titanium oxide may comprise a mass fraction of hafnium in the range of 1 - 4 at.%, preferably 2 - 4 at.%, more preferably 2.5 - 4 at.%, see Fig. 5.

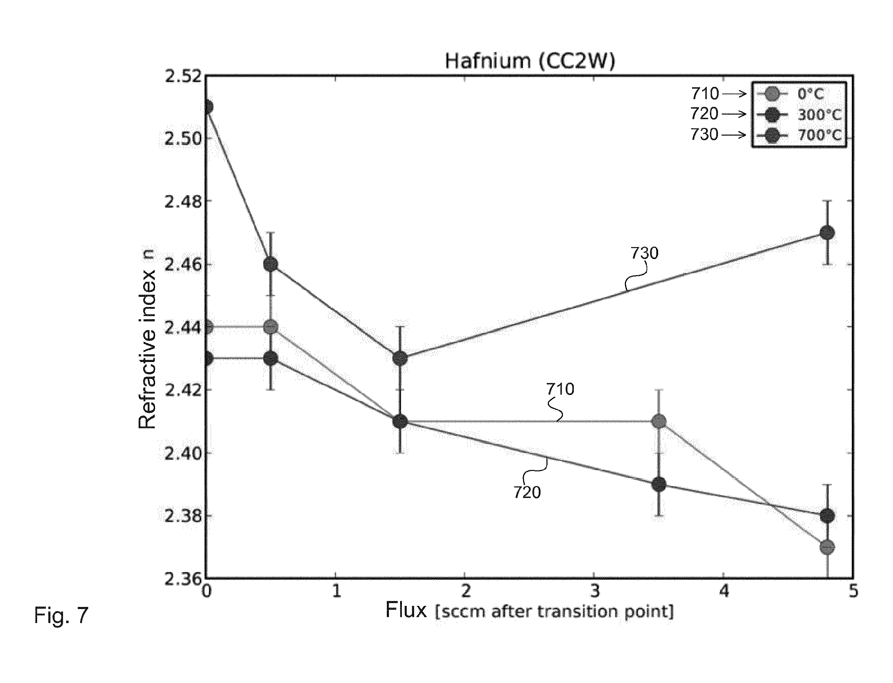

Fig. 7 indicates refractive indices of the titanium oxide layers of Figs. 6A, 6B and 6C vs. oxygen flow during sputtering of the titanium oxide layers. Specifically, graph 710 indicates refractive indices for a titanium oxide layer doped with hafnium without any heating for various oxygen flows, as depicted in Fig. 6A. Graph 720 indicates refractive indices n for a titanium oxide layer doped with hafnium and tempered with a heating to 300°C for various oxygen flows, as depicted in Fig. 6B. Graph 730 indicates refractive indices n for a titanium oxide layer with hafnium as a dopant after being tempered with a heating to 700°C for various oxygen flows, as depicted in Fig. 7C.

The tempering to 300°C (720) does not change the refractive index of the doped titanium oxide coating layer, which conforms to the absence of any crystalline structure in Fig. 6B and which may or may not be understood from the dopant hafnium in a concentration as indicated above preventing the formation of crystal structures such as anatase and rutile altogether during the tempering.

For a tempering to 700°C, the dopant hafnium can prevent the formation of rutile, but cannot entirely prevent the formation of anatase, at least for ordinary values of oxygen flow. Therefore the refractive index 730 is increased over that of the unheated titanium oxide layer 710. However, for an oxygen flow in the range of about 0.5 sccm to 1.5 sccm, corresponding to about 2 - 3 at.% according to Fig. 5, the increase of refractive index can be minimized.

In this way, when providing hafnium as a dopant, optionally with concentration and/or oxygen flux as indicated above, surprisingly a titanium oxide coating layer can be achieved which is generally suitable for coating systems, regardless of whether the coating systems are intended for either no tempering, tempering including a heating to above 250°C, e.g. 300°C, or tempering including a heating to above 550°C, e.g. 700°C. The refractive index can be kept constant during tempering or with a minimal increase only. Anatase structures may be present after tempering to 700°C, however, can be kept on a lower level than compared to undoped titanium oxide layers. Development of rutile structures can be prevented alltogether.

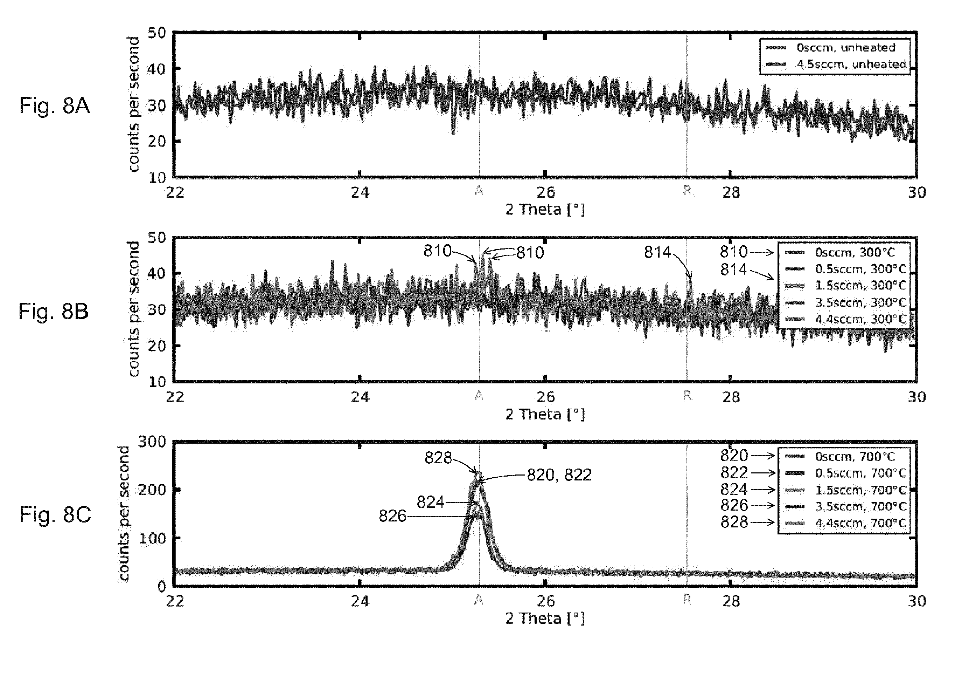

Figs. 8A, 8B and 8C indicate in a similar way as has been described for Figs. 3A - 3C experimental results regarding a crystal structure of a titanium oxide (TiOₓ) layer with tantalum as a dopant material.

Fig. 8A indicates a crystallization of a titanium oxide layer with tantalum prior to any tempering, i.e. without any heating, for different oxygen flows. According to Fig. 8A, the titanium oxide layer with dopant and without heating has an amorphous structure without preference for any crystalline structure.

Fig. 8B indicates a crystallization of a titanium oxide layer with tantalum after a tempering process including a heating to 300°C. From the various graphs representing different oxygen flows, the oxygen flows of 0 sccm and 4.4 sccm are referenced by numerals 810 and 814, respectively. From graph 810, there might be slight evidence for presence of some anatase structures. From graph 814, there might be slight evidence for presence of some rutile structures instead of anatase structures at higher excess oxygen levels. However, as can be clearly inferred from a comparison of count rates in Figs. 8B and 3B, although being heated, the doped titanium oxide layer has essentially not changed its crystallization due to tempering, in contrast to the behaviour of the undoped titanium oxide layer.

Fig. 8C indicates a crystallization of a titanium oxide layer doped with tantalum after a tempering process including a heating to 700°C. The crystallization is indicated for excess oxygen flows of 0 sccm (820), 0.5 sccm (822), 1.5 sccm (824), 3.5 sccm (826), and 4.4 sccm (828).

Generally, due to tempering the titanium oxide layer has changed its crystallization as compared to the layer of Fig. 8A, i.e. anatase structures are present in the tempered layer. However, the presence of any rutile structure can be prevented even for high excess oxygen flows. This is an advantage over the undoped titanium oxide layer of Fig. 3C, which would require high oxygen flows (328) to minimize occurrence of anatase crystals.

Further, an oxygen flux between about 1.5 sccm (824) and about 3.5 sccm (826) results in minimizing the presence of anatase structures. The flows may be somewhat lower than would be applied (328) in the case of the undoped layer in Fig. 3C.

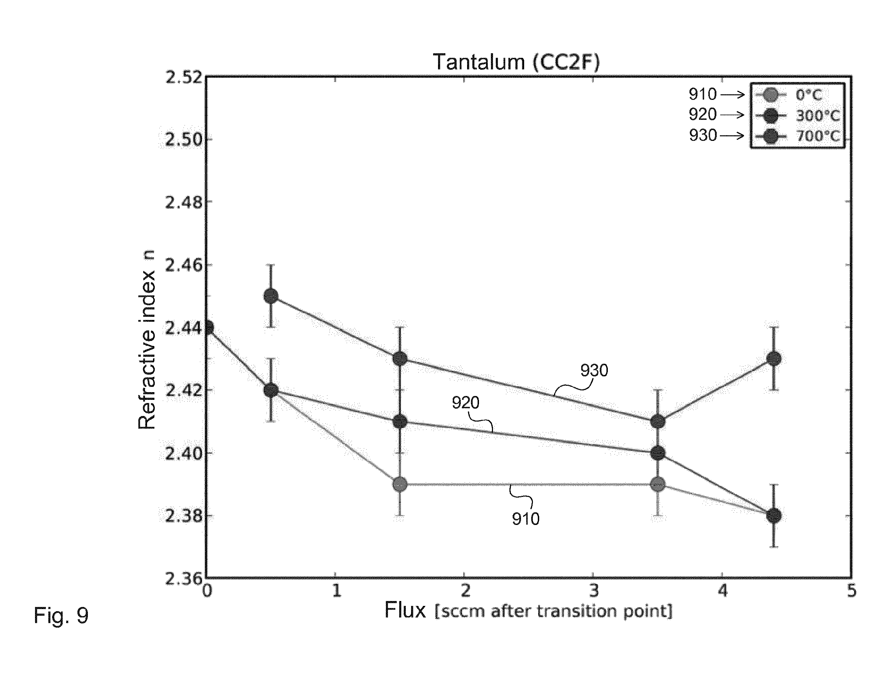

Fig. 9 illustrates refractive indices of the titanium oxide layers of Figs. 8A, 8B and 8C vs. oxygen flow during sputtering of the titanium oxide layers. Specifically, graph 910 indicates refractive indices for a titanium oxide layer doped with tantalum without any heating for various oxygen flows, as depicted in Fig. 8A. Graph 720 indicates refractive indices n for a titanium oxide layer doped with tantalum and tempered with a heating to 300°C for various oxygen flows, as depicted in Fig. 8B. Graph 930 indicates refractive indices for a titanium oxide layer with tantalum as a dopant after being tempered with a heating to 700°C for various oxygen flows, as depicted in Fig. 9C.

The tempering to 300°C (920) tends to slightly increase the refractive index n of the doped titanium oxide coating layer, which conforms to the tendency of few crystalline structures being present according to Fig. 8B and which may be understood from the dopant tantalum in the concentration as discussed below / the oxygen flow during sputtering as discussed above minimizing the formation of anatase or rutile structures but not preventing the formation altogether.

During a tempering to 700°C (930), the dopant tantalum can prevent the formation of rutile, but cannot entirely prevent the formation of anatase. Therefore the refractive index 930 increases over that of the unheated titanium oxide layer.

According to some embodiments, a titanium oxide coating layer with tantalum as a dopant may be provided, wherein a dopant concentration is about 2 at.%, and/or an oxygen flow is set to 0 sccm during sputtering (see Fig. 5). The coating layer can generally be employed and is suitable for no tempering or a tempering to about 300°C of the product, and then minimizes any deterioration of optical properties of the coating and the product which may occur due to the tempering.

According to some embodiments, a sputtering process may comprise sputtering the titanium oxide layer including tantalum and controlling an oxygen flux between about 1.5 sccm and about 3.5 sccm, which enables minimizing the presence of anatase structures and preventing the presence of rutile entirely.

According to various embodiments, a layer of titanium oxide may comprise a mass fraction of tantalum in the range of 2 at.% - 6 at.%, preferably 3.5 - 5 at.% (see Fig. 5). A coating system comprising that titanium oxide layer may generally be employed for any products either to be manufactured without any tempering, a tempering to about 300°C, or a tempering to about 700°C, at least if in the latter case a slight increase in refractive index is tolerable.

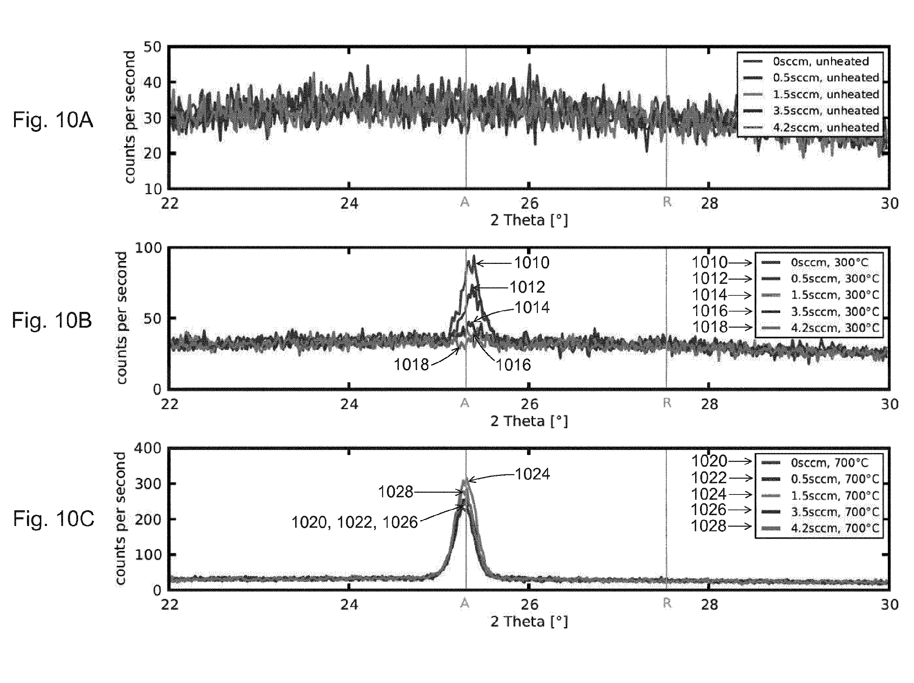

Figs. 10A, 10B and 10C indicate in a similar way as has been described for Figs. 3A - 3C experimental results regarding a crystal structure of a titanium oxide (TiOₓ) layer with tungsten as a dopant material.

Fig. 10A indicates a crystallization of a titanium oxide layer with tungsten prior to any tempering, i.e. without any heating for different oxygen flows. According to Fig. 10A, the titanium oxide layer with dopant and without heating has an amorphous structure without preference for any crystalline structure.

Fig. 10B indicates crystallization of a titanium oxide layer with tungsten after a tempering process including a heating to 300°C. The structures are indicated for oxygen flows of 0 sccm (1010), 0.5 sccm (1012), 1.5 sccm (1014), 3.5 sccm (1016), and 4.2 sccm (1018). Employing tungsten as a dopant may generally prevent formation of rutile during the tempering. Further, an increasing oxygen flow, which might correspond to an increasing concentration of tungsten in the titanium dioxide layer, results in a reduction in the formation of anatase structures in the layer during tempering. Specifically, moderate oxygen flows in the range of about 0 sccm (1020) to 0.5 sccm (1012) lead to a reduction of the presence of anatase structures compared to the undoped but similarly tempered titanium oxide layer of Fig. 3B (see count rates) For oxygen flows above about 1.0 sccm, the formation of anatase structures can essentially be prevented.

Fig. 10C indicates a crystallization of a titanium oxide layer doped with tungsten after a tempering process including a heating to 700°C. The crystallization is indicated for oxygen flows of 0 sccm (1020), 0.5 sccm (1022), 1.5 sccm (1024), 3.5 sccm (1026), and 4.2 sccm (1028).

Generally, due to tempering the titanium oxide layer has changed its crystallization as compared to Fig. 10A, i.e. anatase structures are present in the tempered layer. However, the presence of any rutile structure can be prevented even for low excess oxygen flows, which is an advantage over an undoped titanium oxide layer requiring higher oxygen flows which may be applied to minimize anatase and which is not able to suppress parallel presence of anatase and rutile structures, see Fig. 3C.

However, there is no clear evidence that any specific range of oxygen flow or tungsten concentration can minimize the presence of anatase in the tempered titanium oxide layer.

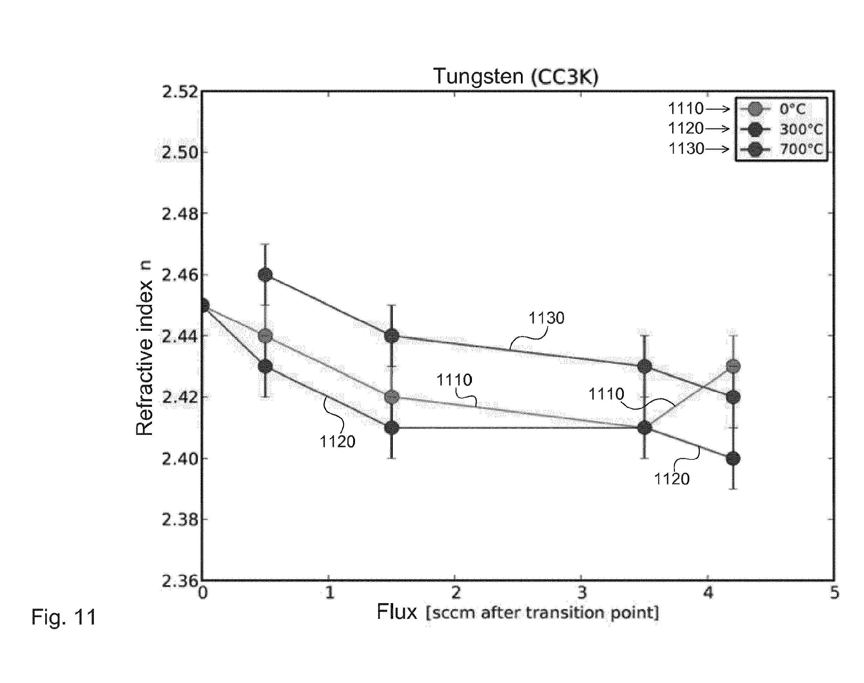

Fig. 11 indicates refractive indices of the titanium oxide layers of Figs. 10A, 10B, and 10C vs. oxygen flow during sputtering of the titanium oxide layers. Specifically, graph 1110 indicates refractive indices for a titanium oxide layer doped with tungsten without any heating for various oxygen flows, as depicted in Fig. 10A. Graph 1120 indicates refractive indices for a titanium oxide layer doped with tungsten and tempered with a heating to 300°C for various oxygen flows, as depicted in Fig. 10B. Graph 1130 indicates refractive indices for a titanium oxide layer with tungsten as a dopant after being tempered with a heating to 700°C for various oxygen flows, as depicted in Fig. 10C.

The tempering to 300°C (1120) does not markedly affect the refractive index n of the doped titanium oxide coating layer, which conforms to the tendency of few anatase crystalline structures being present according to Fig. 10B, and wherein no crystal structures appear to be present for oxygen flows above about 1.5 sccm. Apparently the presence of tungsten in the concentrations / an oxygen flow during sputtering as indicated minimizes the formation of anatase structures or prevents the formation altogether.

During a tempering to 700°C (1130), the dopant tantalum can prevent the formation of rutile, but cannot prevent the formation of anatase, see Fig. 11C. Therefore the refractive index 1130 appears to systematically increase over that of the titanium oxide layer before heating. However, the increase appears to be of the order of 1.6 % for a flux between 0 sccm to 3 sccm, which may be tolerable for various appliances.

According to various embodiments, a titanium oxide coating layer with tungsten as a dopant may be provided, wherein a dopant concentration is in the range of about 1.5 at.% to 2.2 at.%, and/or an oxygen flow during sputtering is in the range of about 0 sccm - 0.5 sccm (see Fig. 5). The coating layer can generally be employed either for no tempering or for a tempering to about 300°C, and minimizes in the latter case a deterioration of optical properties of the coating and the product due to the tempering by preventing formation of rutile and minimizing a formation of anatase.

According to various embodiments, a titanium oxide layer with a concentration of tungsten as a dopant as indicated above, or of another concentration may also be employed for a tempering process to temperatures above 550°C. A formation of rutile may be prevented also in this regime. However, existing experimental data indicate that formation of anatase cannot significantly be reduced as compared to undoped titanium oxide layer. Either because of this or of any other reason, there is a tendency for a slight increase in refractive index. However, tungsten may nevertheless be contemplated as a dopant for coating systems intended for any kind of tempering at least for some embodiments, for example because tungsten can be less costly than other potential dopants.

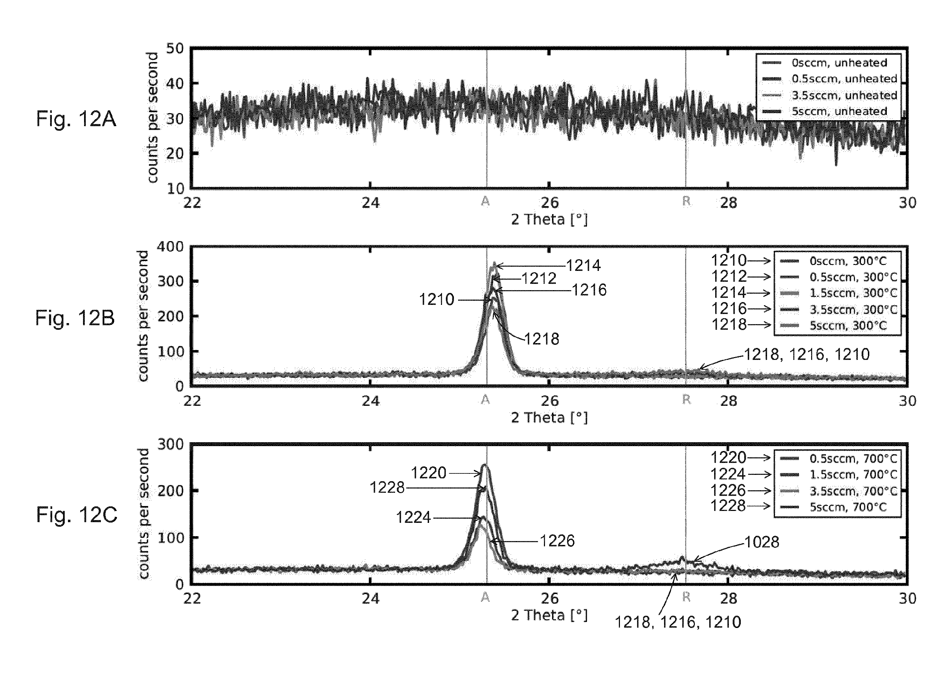

Figs. 12A, 12B and 12C indicate in a similar way as has been discussed for Figs. 3A - 3C experimental results regarding a crystal structure of a titanium oxide (TiOₓ) layer with zirconium as a dopant material.

Fig. 12A indicates a crystallization of a titanium oxide layer with zirconium prior to any tempering, i.e. without any heating, for different oxygen flows. According to

Fig. 12A, the titanium oxide layer with dopant and without heating has an amorphous structure without preference for any crystalline structure.

Fig. 12B indicates a crystallization of a titanium oxide layer with zirconium after a tempering process including a heating to 300°C. The crystallization is indicated for excess oxygen flows of 0 sccm (1210), 0.5 sccm (1212), 1.5 sccm (1214), 3.5 sccm (1216), and 5 sccm (1218). Employing zirconium as a dopant may reduce formation of rutile during the tempering. However, there is a tendency for rutile formation for low oxygen flow (1210) as well as oxygen flows above about 3.5 sccm (1218, 1216).

For low oxygen flows at 0 sccm (1210), as well as for oxygen flow above order 3.5 sccm (1216, 128), anatase formation is reduced as compared to intermediate values of oxygen flow (1212, 1214). However, anatase formation is generally of the order of or even more pronounced than anatase formation in an undoped titanium oxide layer during tempering, see Fig. 3B.

Fig. 12C indicates crystallization of a titanium oxide layer doped with zirconium after a tempering process including a heating to 700°C. The crystallization is indicated for oxygen flows of 0.5 sccm (1222), 1.5 sccm (1224), 3.5 sccm (1226), and 5.0 sccm (1228).

Generally, due to the heating the titanium oxide layer has changed its crystallization as compared to Fig. 12A, i.e. anatase and potentially rutile structures are present in the tempered layer. The presence of rutile can be prevented when restricting the oxygen flow to moderate values below about 5 sccm (1228). Therefore, for moderate oxygen flow and potentially the resulting dopant concentration, an advantage can be realized over an undoped titanium oxide layer which would require higher oxygen flows to suppress parallel presence of anatase and rutile structures, see Fig. 3C.

A moderate oxygen flow between about 1.5 sccm (1224) and about 3.5 sccm (1226) can also minimize the presence of anatase in the tempered titanium oxide layer. These flow rates may be lower than required to minimize anatase formation for an undoped titanium oxide layer, see Fig. 3C. Therefore, a moderate oxygen flow / corresponding dopant concentration can be contemplated to minimize crystallization of titanium oxide when tempering with about 700°C.

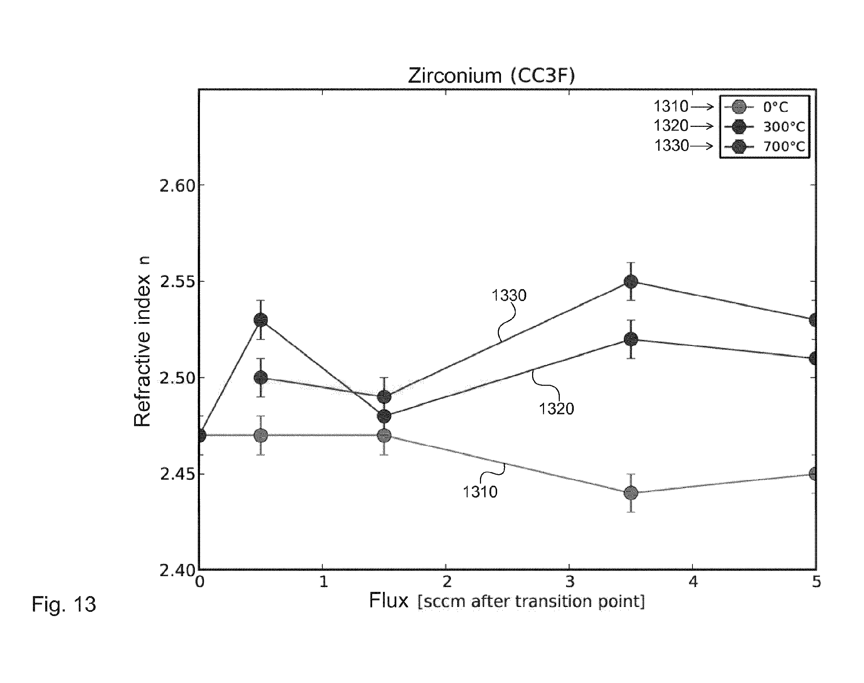

Fig. 13 indicates refractive indices of the titanium oxide layers of Figs. 12A, 12B and 12C vs. oxygen flow during sputtering for the titanium oxide layers. Specifically, graph 1310 indicates refractive indices for a titanium oxide layer doped with zirconium without any heating for various oxygen flows, as depicted in Fig. 12A. Graph 1320 indicates refractive indices for a titanium oxide layer doped with zirconium and tempered with a heating to 300°C for various oxygen flows, as depicted in Fig. 12B. Graph 1330 indicates refractive indices for a titanium oxide layer with zirconium as a dopant after being tempered with a heating to 700°C for various oxygen flows, as depicted in Fig. 12C.

A tempering to 300°C or to 700°C appears to increase the refractive index over that of the unheated doped titanium oxide layer, except for a moderate oxygen flow around 1.5 sccm. This conforms to Figs. 12B and 12C indicating that a moderate oxygen flow / dopant concentration is best suited to avoid formation of rutile and minimize the formation of anatase.

According to various embodiments, a titanium oxide coating layer with zirconium as a dopant may be provided, with a dopant concentration in the range of about 0.8 at.% to 1.8 at.%, preferably between 1.0 at.% and 1.6 at.%, and/or with an oxygen flow of between 1 sccm - 4 sccm during sputtering, preferably between 1.5 sccm - 3.5 sccm (see Fig. 5). The coating layer may generally be employed for either no tempering or a tempering to above 550°C of a product, and may then minimize a deterioration of optical properties of the coating otherwise resulting from the tempering. The effect may be due to a formation of rutile being prevented and a formation of anatase being minimized as compared to an undoped titanium oxide layer. Generally, lower oxygen flows are required for sputtering the doped titanium oxide layer as compared to sputtering the undoped titanium oxide layer.

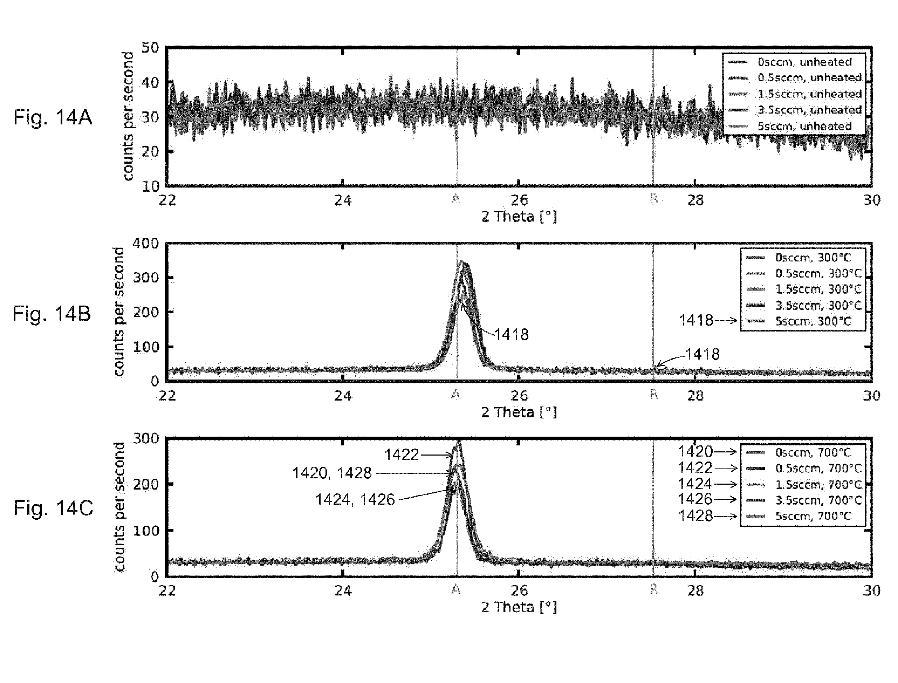

Figs. 14A, 14B and 14C indicate in a similar way as has been described for Figs. 3A - 3C experimental results regarding a crystallization of a titanium oxide (TiOₓ) layer with molybdenum as a dopant material.

Fig. 14A indicates a crystallization of a titanium oxide layer with molybdenum prior to any tempering, i.e. without any heating, for different oxygen flows. According to

Fig. 14A, the titanium oxide layer with dopant and without heating has an amorphous structure without preference for any crystalline structure.

Fig. 14B indicates a crystallization of a titanium oxide layer with molybdenum after a tempering process including a heating to 300°C. Generally, due to the tempering the titanium oxide layer has changed its structure as compared to Fig. 14A, i.e. pronounced anatase structures are present in the tempered layer. Employing molybdenum as a dopant of either concentration appears to prevent formation of rutile during the tempering. The presently available experimental results provide no clear tendency for specific oxygen flows / dopant concentrations particularly suitable for example for minimizing a formation of anatase.

Fig. 14C indicates crystallization of a titanium oxide layer doped with molybdenum after a tempering process including a heating to 700°C. Generally, due to the heating the titanium oxide layer has changed its structure as compared to

Fig. 14A, i.e. anatase structures are present in the tempered layer. The presence of rutile appears however generally to be suppressed, at least for the illustrated oxygen rates.

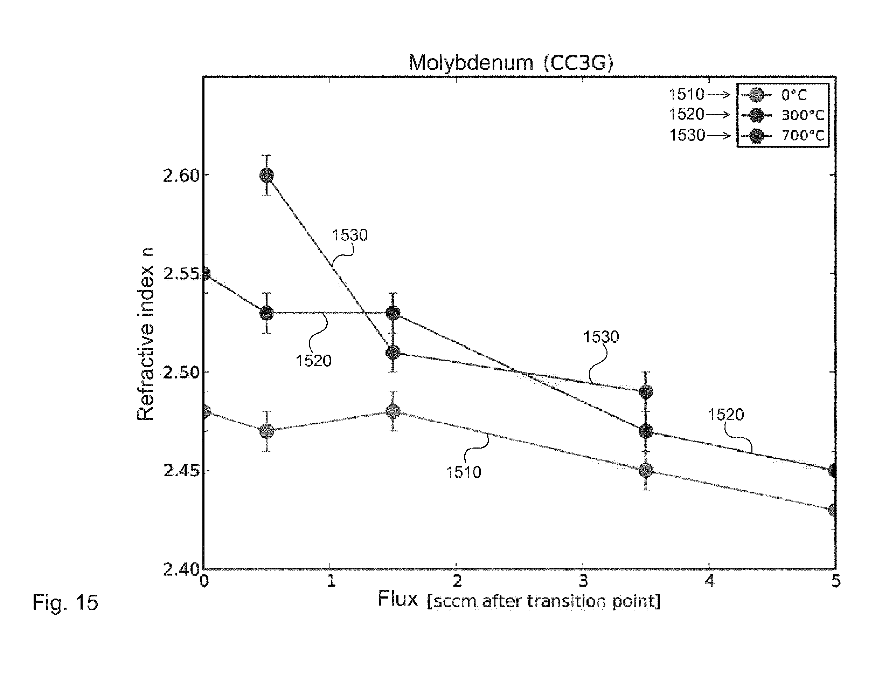

Fig. 15 illustrates refractive indices of the titanium oxide layers of Figs. 14A, 14B and 14C vs. oxygen flow for during sputtering of the titanium oxide layers. Specifically, graph 1510 indicates refractive indices for a titanium oxide layer doped with molybdenum without any heating for various oxygen flows, as depicted in Fig. 14A. Graph 1520 indicates refractive indices for a titanium oxide layer doped with molybdenum and tempered with a heating to 300°C for various oxygen flows, as depicted in Fig. 14B. Graph 1530 indicates refractive indices n for a titanium oxide layer with molybdenum as a dopant after being tempered with a heating to 700°C for various oxygen flows, as depicted in Fig. 14C.

A tempering to 300°C (1520) or to 700°C (1530) appears to increase the refractive index over that of the unheated doped titanium oxide layer (1510). This conforms to Figs. 14B and 14C indicating the pronounced formation of anatase.

According to various embodiments, a titanium oxide coating layer with molybdenum as a dopant may be provided, wherein a dopant concentration is in the range of about 0.8 at.% or more, and/or an oxygen flow is set to 0 sccm or more during sputtering (see Fig. 5). The coating layer can be employed for no tempering or a tempering to any temperature. A doping with molybdenum can prevent the parallel presence of the different crystalline structures anatase and rutile in the tempered titanium oxide layer, however at the expense of pronounced anatase structures.

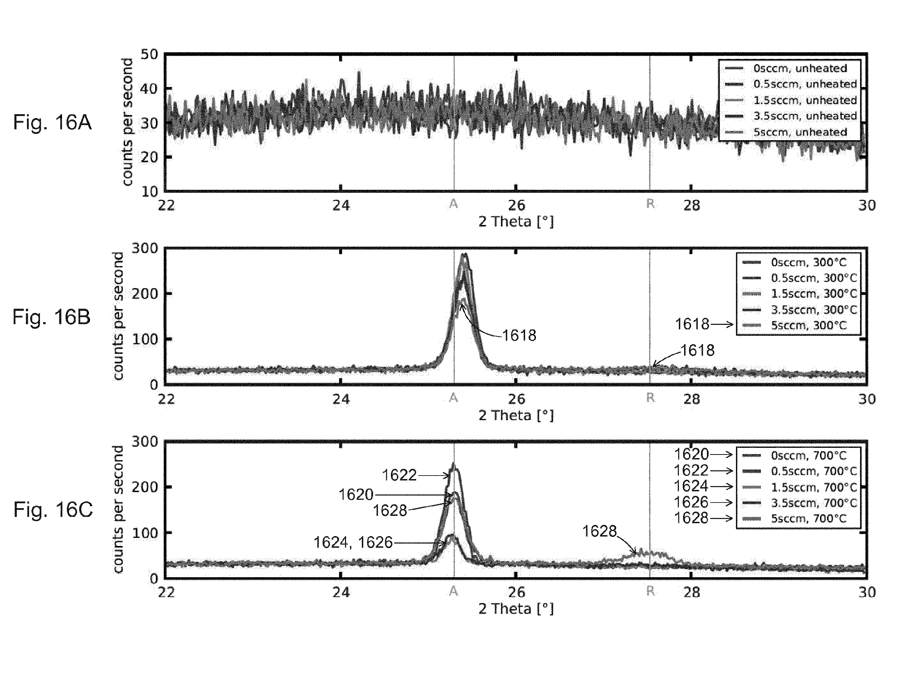

Figs. 16A, 16B and 16C indicate in a similar way as has been described for Figs. 3A - 3C experimental results regarding a crystal structure of a titanium oxide (TiOₓ) layer with vanadium as a dopant material.

Fig. 16A indicates a crystallization of a titanium oxide layer with vanadium prior to any tempering, i.e. without any heating, for different oxygen flows. According to Fig. 16A, the titanium oxide layer with dopant and without heating has an amorphous structure without preference for any specific crystalline structure.

Fig. 16B indicates a crystallization of a titanium oxide layer with vanadium after a tempering process including a heating to 300°C. Generally, due to the heating the titanium oxide layer has changed its crystallization as compared to the layer of Fig. 16A, i.e. anatase structures are present in the tempered layer. The presently available experimental results provide no clear tendency for specific oxygen flows or dopant concentrations particularly suitable for minimizing a formation of anatase, except that for large oxygen flows of order 5 sccm (1618) the anatase formation appears to be suppressed. However, while employing vanadium as a dopant may prevent formation of rutile during the tempering, there is a tendency for rutile formation for high oxygen flows of 5 sccm (1618).

Fig. 16C indicates crystallization of a titanium oxide layer doped with vanadium after a tempering process including a heating to 700°C. The crystallization is indicated for oxygen flows of 0.0 sccm (1620), 0.5 sccm (1622), 1.5 sccm (1624), 3.5 sccm (1426), and 5.0 sccm (1628).

Generally, due to the tempering the titanium oxide layer has changed its structure as compared to the layer of Fig. 16A, i.e. anatase structures are present in the tempered layer. A range of oxygen flow between about 1 sccm - 4 sccm, preferably about 1.5 sccm (1624) - 3.5 sccm (1626) minimizes the presence of anatase in the tempered titanium oxide layer in comparison to a tempered undoped titanium oxide layer, see Fig. 3C. Further, the indicated oxygen flow rates may be lower than required for minimizing an anatase formation in an undoped titanium oxide layer.

Moreover, the presence of rutile can be prevented in the indicated flow ranges, i.e., rutile formation sets in only for higher oxygen flows of about 5 sccm (1628). Therefore, moderate flow rates and/or a moderate amount of vanadium as a dopant can be contemplated to minimize a general crystallization of titanium oxide when tempering with about 700°C.

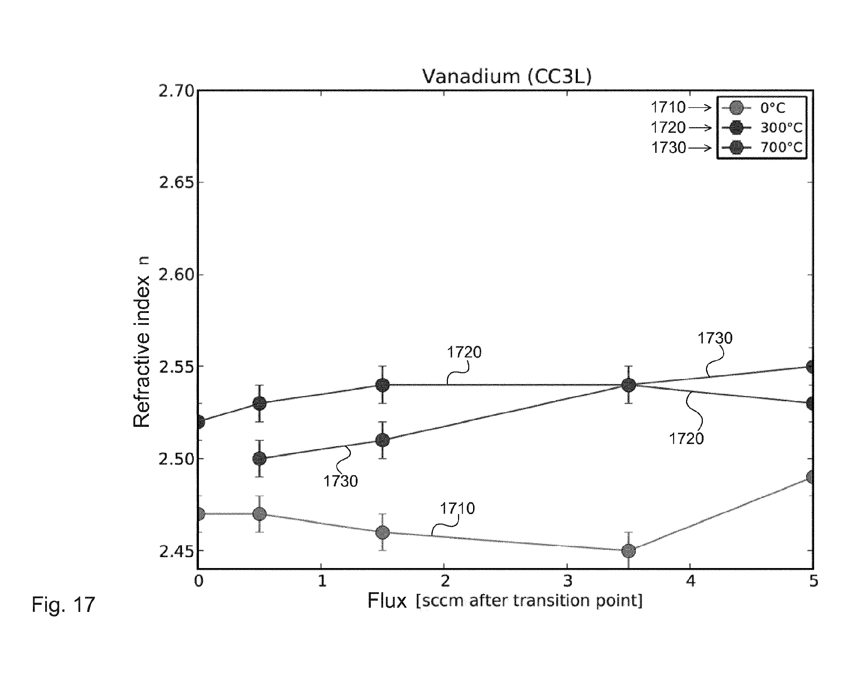

Fig. 17 illustrates refractive indices of the titanium oxide layers of Figs. 16A, 16B and 16C vs. oxygen flow during sputtering of the titanium oxide layers. Specifically, graph 1710 indicates refractive indices for a titanium oxide layer doped with vanadium without any heating for various oxygen flows, as depicted in Fig. 16A. Graph 1720 indicates refractive indices for a titanium oxide layer doped with vanadium and tempered with a heating to 300°C for various oxygen flows, as depicted in Fig. 16B. Graph 1730 indicates refractive indices n for a titanium oxide layer with vanadium as a dopant after being tempered with a heating to 700°C for various oxygen flows, as depicted in Fig. 16C.

The tempering at 300°C (1720) increases the refractive index over that of the doped titanium oxide layer prior to heating, which conforms to Fig. 16B showing the pronounced formation of anatase. A tempering at 700°C (1730) appears to result in a lesser increase of the index, in particular for a lower oxygen flow. At a higher oxygen flow around 5 sccm, the onset of rutile formation may contribute to a further increasing refractive index.

According to various embodiments, a coating layer of titanium oxide doped with vanadium may be provided, wherein a dopant concentration is in the range of about 1.0 at.% - 1.6 at.%, preferably between about 1.1 at.% - 1.5 at.%, with a tendency towards the lower values for reducing the refractive index, and/or an oxygen flow is set between 1 sccm - 4 sccm, preferably between about 1.5 sccm - 3.5 sccm (see Fig. 5). The titanium oxide coating layer can be generally employed for either no tempering or for a tempering to more than 550°C of a product. In the latter configuration, a doping with vanadium can prevent the parallel presence of the different crystalline structures anatase and rutile in the tempered titanium oxide layer, while at the same time decreasing the presence of anatase structures as compared to an undoped layer. A sputtering of the doped coating layer can be performed with lower oxygen flows than for the undoped layer when attempting to minimize crystallization during tempering.

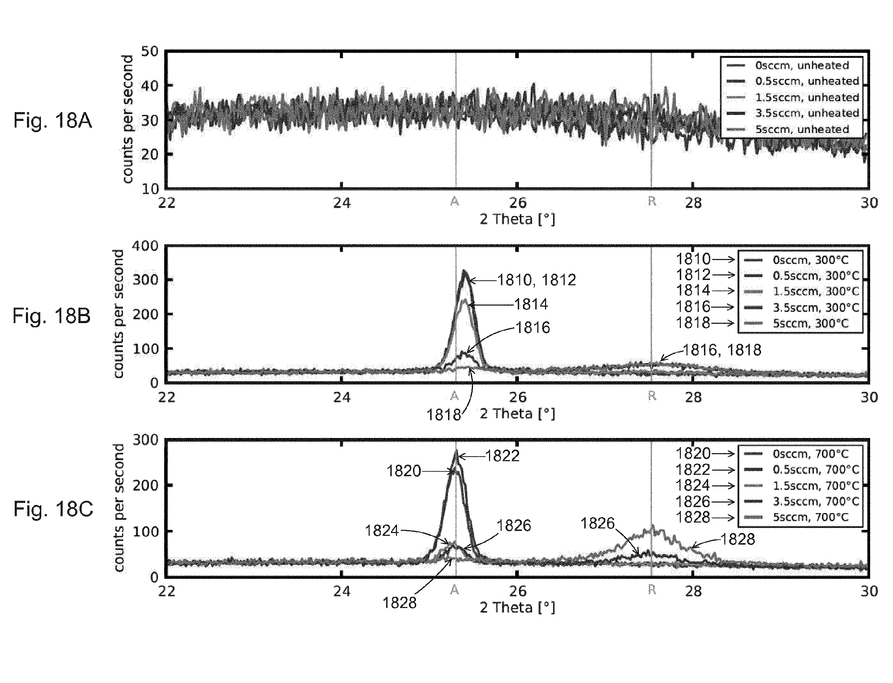

Figs. 18A, 18B and 18C indicate in a similar way as has been described for Figs. 3A - 3C experimental results regarding a crystal structure of a titanium oxide (TiOₓ) layer with chromium as a dopant material.

Fig. 18A indicates a crystallization of a titanium oxide layer with chromium prior to any tempering, i.e. without any heating, for different oxygen flows. According to Fig. 18A, the titanium oxide layer with dopant and without heating has an amorphous structure without preference for any specific crystalline structure.

Fig. 18B indicates a crystallization of a titanium oxide layer with chromium after a tempering process including a heating to 300°C. The crystal structures are indicated for oxygen flows of 0.0 sccm (1810), 0.5 sccm (1812), 1.5 sccm (1814), 3.5 sccm (1816), and 5.0 sccm (1818) after the transition point.

Generally, due to the heating the titanium oxide layer has changed its structure as compared to the layer of Fig. 18A, i.e. anatase structures are present in the tempered layer except for high oxygen flows, when however rutile is present. More specifically, for oxygen flows above about 1.5 sccm (1814), anatase formation is more and more suppressed. For an oxygen flow at about 3.5 sccm (1816), anatase formation is suppressed also in comparison to a tempered undoped titanium oxide layer, see Fig. 3B. However, for oxygen flows of 3.5 sccm or more (1816, 1818), measurable rutile formation occurs. In other words, for oxygen flows of more than 3.5 sccm and corresponding dopant concentrations, the titanium oxide layer can be controlled to comprise essentially only rutile as a crystal structure.

Fig. 18C indicates a crystallization of a titanium oxide layer doped with chromium after a tempering process including a heating to 700°C. The crystallization is indicated for excess oxygen flows of 0.0 sccm (1820), 0.5 sccm (1822), 1.5 sccm (1824), 3.5 sccm (1826), and 5.0 sccm (1828).

Generally, due to the heating the titanium oxide layer has changed its structure as compared to the layer of Fig. 18A, i.e. anatase and/or rutile structures are present in the tempered layer. Specifically, an oxygen flow of about 1 sccm or more, preferably about 1.5 sccm (1824) or more, minimizes the presence of anatase in the tempered titanium oxide layer also in comparison to a tempered undoped titanium oxide layer, see Fig. 3C. The indicated oxygen amounts may be lower than required for an undoped titanium oxide layer to minimize anatase formation.

The presence of rutile can be prevented for low oxygen flows, while an onset of rutile formation is detected for about 3.5 sccm or more (1826, 1828). Therefore, two different regimes can be envisaged: At moderate flow rates in the range of about 1 sccm to 2 sccm or 3 sccm of oxygen flux, anatase formation can be minimized also in comparison to a tempered undoped titanium oxide layer, see Fig. 3C. For amounts of 3.5 sccm or more, the formation of anatase can be minimized or prevented altogether, however, rutile forms during the tempering.

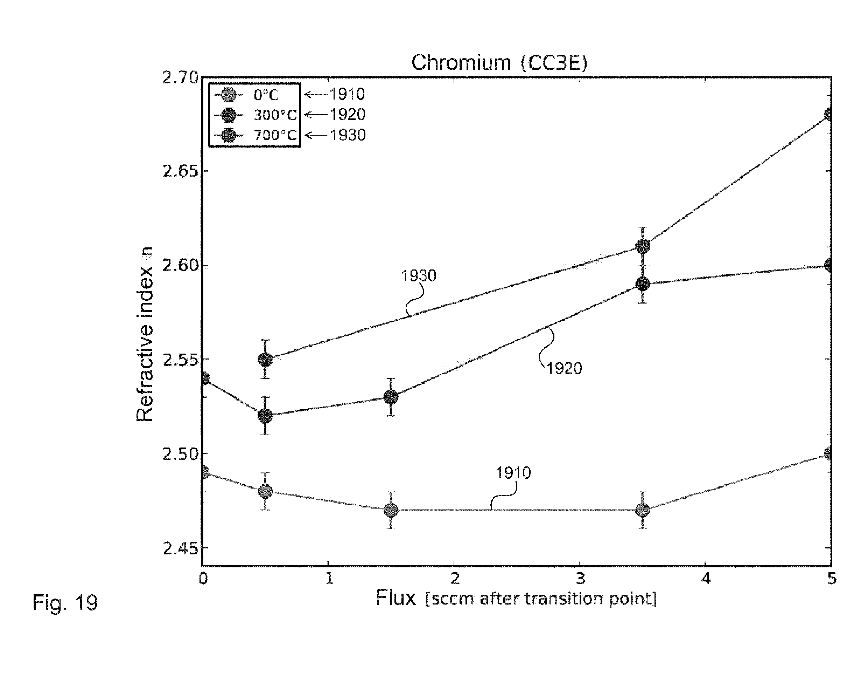

Fig. 19 illustrates refractive indices of the titanium oxide layers of Figs. 18A, 18B and 18C vs. oxygen flow during sputtering of the titanium oxide layers. Specifically, graph 1910 indicates refractive indices for a titanium oxide layer doped with chromium without any heating for various oxygen flows, as depicted in Fig. 18A. Graph 1920 indicates refractive indices for a titanium oxide layer doped with chromium and tempered with a heating to 300°C for various oxygen flows, as depicted in Fig. 18B. Graph 1930 indicates refractive indices for a titanium oxide layer with chromium as a dopant after being tempered with a heating to 700°C for various oxygen flows, as depicted in Fig. 18C.

Any tempering increases the refractive index over that of the unheated doped titanium oxide layer. Specifically, the index increases for a tempering at 300°C with increasing oxygen flow, which conforms to Fig. 18B showing decreasing formation of anatase, but increasing formation of rutile. A tempering at 700°C shows a similar behaviour, however more pronounced, which conforms to Fig. 18C showing the pronounced appearance of rutile at higher oxygen flows. According to various embodiments, a coating system may be provided which comprises a coating layer of titanium oxide doped with chromium, wherein a dopant concentration may be in the range of about 2.5 at.% or more, preferably 3.2 at.% or more, more preferably 3.9 at.% or more, and/or an oxygen flow is set to 2.5 sccm or more, preferably 3.5 sccm or more, more preferably 5 sccm or more (see Fig. 5). The coating system may generally be employed for no tempering or for a tempering at more than 250°C of a product coated with the system. After tempering, a crystallization is generally minimized as compared to a tempered undoped titanium oxide layer, see Fig. 3B. For high dopant concentration, anatase is suppressed and the layer comprises only rutile as a crystallization. However, the refractive index increases for increasing dopant concentration. A compromise to on the one hand minimize stresses in the tempered layer and on the other hand minimize changes of refractive index may comprise to select an intermediate dopant concentration, for example around values of 2.5 at.% - 3.0 at.%.

According to various embodiments, a coating system may comprise a coating layer of titanium oxide doped with chromium, wherein a dopant concentration is selected in the range of about 1.8 at.% - 3.1 at.%, preferably 2.1 at.% - 3.0 at.%, and/or wherein an oxygen flow is set between 1.0 sccm - 3.5 sccm, preferably 1.5 sccm - 3.0 sccm (see Fig. 5). The coating system may generally be employed for either no tempering or for a tempering at more than 550°C of the product. An anatase formation is generally minimized during tempering as compared to an undoped titanium oxide layer, see Fig. 3B. Rutile formation can be avoided or minimized within the indicated dopant ranges. The refractive index is increased over that of the undoped configuration, but is less than it would be for higher dopant concentrations.

According to various embodiments, a coating system may comprise a coating layer of titanium oxide doped with chromium, wherein a dopant concentration is selected in the range of about 2.5 at.% - 3.0 at.%, and/or wherein an oxygen flow is set between 2.5 sccm - 3.0 sccm (see Fig. 5). The coating system may generally be employed for no tempering, or for a tempering at more than 250°C of the product, or for a tempering at more than 550°C. The general applicability of the coating system is a compromise which provides for some degree of minimized formation of anatase and/or rutile during either tempering.

According to various embodiments, a coating system may comprise a coating layer of titanium oxide doped with chromium, wherein a dopant concentration is in the range of about 3.2 at.% or more, preferably 3.5 at.% or more, and/or an oxygen flow is set to 3.5 sccm or more, preferably 4.0 sccm or more (see Fig. 5). The coating system may generally be employed for no tempering, or for a tempering at more than 250°C of the product, or for a tempering at more than 550°C. The general applicability of the coating system is a compromise for minimizing or preventing the formation of anatase, however accepting the formation of rutile and a high refractive index after tempering.

Various embodiments of the invention propose a set of one or more dopants for a titanium oxide layer of a coating system on a substrate. According to various embodiments of the invention, a sputtering process may specifically be controlled with regard to an oxygen flux in a sputtering configuration. According to various embodiments of the invention, specific ranges of dopant concentration are provided. Various embodiments of the invention provide a coating system which may generally be used for coating a substrate, regardless whether or not a tempering of a product comprising substrate and coating system is intended.

According to various embodiments of the invention, a dopant, a dopant concentration, and/or a specific oxygen flux in a sputtering configuration may be selected to achieve one or more of generally minimizing a crystallization of the titanium oxide layer during tempering, minimizing a formation of different crystal forms such as anatase and/or rutile, minimizung a required oxygen flow during sputtering of the doped titanium oxide layer, minimizing a change of refractive index of the titanium oxide layer due to the tempering, etc.

While the invention has been described in relation to its preferred embodiments, it is to be understood that this description is intended non-limiting and for illustrative purposes only. In particular, various combinations of features wherein the features have been described separately hereinbefore are apparent as advantageous or appropriate to the skilled artisan. Accordingly, it is intended that the invention be limited only by the scope of the claims appended hereto.

## Claims

1. A temperature resistant coating system for a transparent substrate,
wherein the coating system (102) comprises a layer of titanium oxide (108),
**characterized in that**
the layer of titanium oxide (108) comprises at least one of hafnium, tantalum, tungsten, zirconium, molybdenum, vanadium, chromium, and manganese.

2. The coating system according to claim 1,
**characterized in that**
the coating system (102) further comprises a layer of silver (106).

3. The coating system according to claim 2,
**characterized in that**
the layer of silver (106) is provided above the substrate (102), and the layer of titanium oxide (108) is provided above the layer of silver (106).

4. The coating system according to any of the preceding claims,
**characterized in that**
the layer of titanium oxide (108) comprises hafnium.

5. The coating system according to claim 4,
**characterized in that**
the layer of titanium oxide (108) comprises a mass fraction of hafnium in the range of 1 at.% - 4 at.%, preferably 2 at.% - 3 at.%.

6. The coating system according to any of the preceding claims,
**characterized in that**
the layer of titanium oxide (108) comprises a mass fraction of tantalum in the range of 2 at.% - 6 at.%, preferably 3.5 at.% - 5 at.%.

7. The coating system according to any of the preceding claims,
**characterized in that**
the layer of titanium oxide (108) comprises a mass fraction of zirconium in the range of 0.5 at.% - 1.5 at.%, preferably 1 at.% - 1.5 at.%.

8. The coating system according to any of the preceding claims,
**characterized in that**
the layer of titanium oxide (108) comprises a mass fraction of vanadium in the range of 0.8 at.% - 1.5 at.%, preferably 1 at.% - 1.2 at.%.

9. The coating system according to any of the preceding claims,
**characterized in that**
the layer of titanium oxide (108) comprises a mass fraction of chromium in the range of 1.5 at.% - 3 at.%, preferably 2 at.% - 3 at.%.

10. A product (100) comprising a substrate (104) coated with a coating system (102) according to any one of the preceding claims,
wherein the product (100) comprises at least one of sheet glass, low-E glass, architectural glass, safety glass, antireflective glass, and glass for solar panels.

11. The product according to claim 10,
wherein the product has been tempered with at least 250°C, and/or has been tempered with at least 550°C.

12. A method of coating a substrate with a coating system according to any one of claims 1 - 9,
wherein a sputtering process (204) is performed for coating the substrate (104) with the titanium oxide layer (108).

13. The method according to claim 12,
wherein the sputtering process (204) comprises sputtering the titanium oxide layer (108) including hafnium and an excess oxygen flux (120) is set to a value in the range 0.2 sccm - 2.0 sccm, preferably 0.5 sccm - 1.5 sccm.

14. The method according to claim 12,
wherein the sputtering process (204) comprises sputtering the titanium oxide layer (108) including zirconium and an excess oxygen flux is set to a value in the range 1 sccm - 4 sccm, preferably 1.5 sccm - 3.5 sccm.

15. The method according to claim 12,
wherein the sputtering process (204) comprises sputtering the titanium oxide layer (108) including chromium and an excess oxygen flux is set to a value in the range 1 sccm - 3.5 sccm, preferably 1.5 sccm - 3 sccm.
